(19) Europäisches Patentamt
European Patent Office
Office européen des brevets

(11) **EP 4 546 173 A1**

(12) **EUROPEAN PATENT APPLICATION**
published in accordance with Art. 153(4) EPC

(43) Date of publication:
**30.04.2025  Bulletin 2025/18**

(21) Application number: **23838674.2**

(22) Date of filing: **25.06.2023**

(51) International Patent Classification (IPC):
*G06F 17/16* *(2006.01)*

(52) Cooperative Patent Classification (CPC):
**G06F 17/16**

(86) International application number:
**PCT/CN2023/102182**

(87) International publication number:
**WO 2024/012180 (18.01.2024 Gazette 2024/03)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **15.07.2022  CN 202210835952**

(71) Applicant: **Huawei Technologies Co., Ltd.
Shenzhen, Guangdong 518129 (CN)**

(72) Inventor: **LIN, Tengyi
Shenzhen, Guangdong 518129 (CN)**

(74) Representative: **Gill Jennings & Every LLP
The Broadgate Tower
20 Primrose Street
London EC2A 2ES (GB)**

(54) **MATRIX CALCULATION METHOD AND DEVICE**

(57)     A matrix computing method and apparatus are provided. In the method, block division is performed by row on input data of a to-be-multiplied first matrix at a granularity of a subblock whose scale is M×N, to obtain at least one first subblock; and block division is performed by column on input data of a to-be-multiplied second matrix at a granularity of a subblock whose scale is N×R, to obtain at least one second subblock, where all M, N, and R are positive integers. One or more target subblock combinations are determined, where each target subblock combination includes one first subblock and one second subblock, and at least one element in the first subblock and at least one element in the second subblock in each target subblock combination are to-be-multiplied elements. Each of the one or more target subblock combinations is used as input data of a matrix computing apparatus, to obtain a product result of the first matrix and the second matrix that is output by the matrix computing apparatus.

FIG. 6

**Description**

**CROSS-REFERENCE TO RELATED APPLICATIONS**

This application claims priority to Chinese Patent Application No. 202210835952.X, filed with the China National Intellectual Property Administration on July 15, 2022 and entitled "MATRIX COMPUTING METHOD AND APPARATUS", which is incorporated herein by reference in its entirety.

**TECHNICAL FIELD**

This application relates to the field of sparse matrix technologies, and in particular, to a matrix computing method and apparatus.

**BACKGROUND**

A matrix multiplication is a basic algorithm for a digital signal, and is also a basic operation of many scientific computing methods. The matrix multiplication is widely used in the fields such as digital image processing, computer vision fast processing and industrial real-time control. However, in an actual application, a matrix scale is usually large, and a matrix multiplication algorithm has high complexity and low processing efficiency, which becomes a bottleneck that restricts system performance improvement. Therefore, designing a high-performance hardware structure for such an application is a current research hot issue of a chip.

Although many matrix multiplication accelerator designs are proposed in recent years, there is a lack of discussion and support for acceleration of a non-uniform sparse matrix. A sparse matrix means that most elements are zero and non-zero elements are distributed irregularly. This even sparse matrix usually has a large scale, and is widely used in many modern application fields such as the hot fields, for example, artificial intelligence, big data, and image processing, and the fields, for example, computational fluid dynamics, statistical physics, circuit simulation, image processing, and even cosmic exploration. In these application fields, a matrix multiplication operation occupies a main part of a computing amount.

Storage resources and computing resources on a chip are very limited. Therefore, currently, a matrix multiplication operation for a sparse matrix is mainly implemented in a software manner, and a speed in a computing process is slow, which cannot meet a real-time processing requirement. Therefore, providing a matrix multiplication accelerator that supports the sparse matrix, to obtain higher computing efficiency and better adapt to an acceleration requirement of a modern application has become a key technical issue to be urgently resolved.

**SUMMARY**

This application provides a matrix computing method and apparatus, to accelerate a multiplication operation of a sparse matrix.

According to a first aspect, an embodiment of this application provides a matrix computing method. The method includes: for a to-be-multiplied first matrix and a to-be-multiplied second matrix, performing, by row, block division on input data of the first matrix at a granularity of a subblock whose scale is M×N, to obtain at least one subblock (denoted as a first subblock), and performing, by column, block division on input data of the second matrix at a granularity of a subblock whose scale is N×R, to obtain at least one subblock (denoted as a second subblock), where all M, N, and R are positive integers; determining one or more target subblock combinations, where each target subblock combination includes one first subblock and one second subblock, and at least one element in the first subblock and at least one element in the second subblock in each target subblock combination are to-be-multiplied elements; and using each of the one or more target subblock combinations as input data of a matrix computing apparatus, to obtain a product result of the first matrix and the second matrix that is output by the matrix computing apparatus.

According to the foregoing design, the input data of the first matrix is divided into one or more first subblocks by row. The input data of the second matrix is divided into one or more second subblocks by column. The one or more target subblock combinations are determined based on data included in each first subblock and data included in each second subblock. The first subblock and the second subblock in each target subblock combination are used as the input data of the matrix computing apparatus, to obtain the product result of the first subblock and the second subblock. The input data of the first matrix may be a sparse code of the first matrix, or the input data of the second matrix may be a sparse code of the second matrix. Block division is performed on the input data of the first matrix and the input data of the second matrix, and a product result of each target subblock combination is computed based on the matrix computing apparatus, to complete a multiplication operation of the first matrix and the second matrix. This can accelerate a multiplication operation of a sparse matrix that is on any scale, has any spareness, and has a random distribution of non-zero elements.

In a possible implementation, the first matrix is a sparse matrix. The input data of the first matrix includes a value of a non-zero element of the first matrix and location information of the non-zero element. The location information indicates a location of the non-zero element in the first matrix. The second matrix is a dense matrix. The input data of the second matrix includes a value of an element of the second matrix and location information of the element. The location information indicates a location of the element in the second matrix.

According to the foregoing design, in this application, a multiplication operation of the sparse matrix and the dense matrix can be accelerated.

In a possible implementation, the first matrix is a sparse matrix. The input data of the first matrix includes a value of a non-zero element of the first matrix and location information of the non-zero element. The location information indicates a location of the non-zero element in the first matrix. The second matrix is a sparse matrix. The input data of the second matrix includes a value of a non-zero element of the second matrix and location information of the non-zero element. The location information indicates a location of the non-zero element in the second matrix.

According to the foregoing design, in this application, a multiplication operation of the sparse matrix and the sparse matrix can be accelerated.

In a possible implementation, the input data of the first matrix is a sparse code of the first matrix. The sparse code is obtained by coding an element in the first matrix.

According to the foregoing design, when the first matrix is sparsely coded, internal storage space required for storing and operating the first matrix can be reduced.

In a possible implementation, a format of the sparse code of the first matrix includes a compressed sparse row CSR format and a coordinate COO format.

According to the foregoing design, when the input data of the first matrix is the sparse code in the CSR or COO format, block division can be performed on the input data of the first matrix more conveniently and quickly by row.

In a possible implementation, if the second matrix is a sparse matrix, the input data of the second matrix is a sparse code of the second matrix. The sparse code is obtained by coding an element in the second matrix.

According to the foregoing design, when the second matrix is sparsely coded, internal storage space required for storing and operating the second matrix can be reduced.

In a possible implementation, a format of the sparse code of the second matrix includes the compressed sparse column CSC format and a coordinate COO format.

According to the foregoing design, when the input data of the second matrix is the sparse code in the CSC or COO format, block division can be performed on the input data of the second matrix more conveniently and quickly by column.

In a possible implementation, the location information indicates a row number and a column number of the non-zero element. The to-be-multiplied element means that a column number of an element in the first subblock is the same as a row number of an element in the second subblock.

According to the foregoing design, the to-be-multiplied elements are determined based on the location information of the non-zero element in the first subblock and the location information of the non-zero element in the second subblock.

In a possible implementation, the determining one or more target subblock combinations includes:

dividing the at least one first subblock and the at least one second subblock into a plurality of subblock combinations, where each subblock combination includes any first subblock and any second subblock;
for each subblock combination, determining a column number range of an element in the first subblock in the subblock combination and a row number range of an element in the second subblock in the subblock combination; and
if there is an intersection between the column number range and the row number range, determining that the subblock combination is the target subblock combination; or if there is no intersection between the column number range and the row number range, determining that the subblock combination is not the target subblock combination.

According to the foregoing design, when the to-be-multiplied elements are determined, a column number range of the first subblock and a row number range of the second subblock are compared, to greatly reduce a quantity of comparison times, and further shorten data preparation duration, so as to shorten matrix multiplication operation duration.

In a possible implementation, the matrix computing apparatus is configured to compute a product result of the first subblock and the second subblock based on the input to-be-multiplied elements in the first subblock and the second subblock.

According to the foregoing design, the matrix computing apparatus provided in this application can identify the to-be-multiplied elements in the first subblock and the second subblock, and perform a multiplication operation on the to-be-multiplied elements. In this way, the matrix computing apparatus can support a multiplication operation of a sparse matrix multiplication operation, and can improve efficiency of the multiplication operation.

In a possible implementation, the matrix computing apparatus determines the product result of the first matrix and the second matrix in the following manner:

dividing all the target subblock combinations into a plurality of sets, where one or more first subblocks included in one or more target subblock combinations in each set are located in a same row of the first matrix, and one or more second subblocks included in the one or more target subblock combinations in each set are located in a same column of the second matrix; and for each set, sequentially inputting the one or more target subblock combinations in the set into the matrix computing apparatus, and computing, by the matrix computing apparatus, a product result of each target subblock combination, and adding product results of the one or more target subblock combinations in the set, where an addition result is one subblock in the product result of the first matrix and the second matrix.

According to the foregoing design, the matrix computing apparatus provided in this application can add product results of a plurality of target subblock combinations, to obtain the product result of the first matrix and the second matrix.

According to a second aspect, an embodiment of this application provides a matrix computing apparatus. The matrix computing apparatus includes an input interface, a comparison unit, and a computing unit.

The input interface is configured to obtain input data of a to-be-multiplied first submatrix and input data of a to-be-multiplied second submatrix. The input data of the first submatrix includes a value of an element in the first submatrix and location information indicating a location, in a first matrix, of a non-zero element in the first submatrix. The input data of the second submatrix includes a value of an element in the second submatrix and location information indicating a location, in a second matrix, of a non-zero element in the second submatrix.

The comparison unit is configured to compare location information of any non-zero element in the first submatrix with location information of any non-zero element in the second submatrix, to determine one or more pairs of to-be-multiplied elements in the first submatrix and the second submatrix.

The computing unit is configured to perform a multiply-add operation on the one or more pairs of to-be-multiplied elements, to obtain a product result of the first submatrix and the second submatrix.

In a possible implementation, the location information includes a row number and a column number of the non-zero element.

The comparison unit is specifically configured to: compare whether a column number of any element in the first submatrix is the same as a row number of any element in the second submatrix; and if the column number of the any element in the first submatrix is the same as the row number of the any element in the second submatrix, determine that the any element in the first submatrix and the any element in the second submatrix are a pair of to-be-multiplied elements, or if the column number of the any element in the first submatrix is different from the row number of the any element in the second submatrix, determine that the any element in the first submatrix and the any element in the second submatrix are not to-be-multiplied elements.

In a possible implementation, when performing the multiply-add operation on the one or more pairs of to-be-multiplied elements, the computing unit is specifically configured to:
perform, based on any row vector in the first submatrix and any column vector in the second submatrix, the multiply-add operation on a to-be-multiplied element included in the row vector and a to-be-multiplied element included in the column vector, to obtain a vector product result of the row vector and the column vector, where the vector multiply-add result is an element in the product result of the first submatrix and the second submatrix.

In a possible implementation, the computing unit is further configured to: add the product result to a third submatrix stored in an accumulator, and write an addition result back to the accumulator.

In a possible implementation, the matrix computing apparatus further includes a detection module. The detection module is configured to detect whether the first submatrix and the second submatrix are overlap matrices. The overlap matrices mean that at least one element in the first submatrix and at least one element in the second subblock are to-be-multiplied elements.

In a possible implementation, the to-be-multiplied element means that a column number of an element in the first subblock is the same as a row number of an element in the second subblock.

In a possible implementation, the comparison unit includes at least one comparator, and the at least one comparator.

According to a third aspect, an embodiment of this application provides a matrix acceleration apparatus. The apparatus includes a processor and a matrix computing apparatus.

The processor is configured to: perform, by row, block division on input data of a to-be-multiplied first matrix at a granularity of a subblock whose scale is M×N, to obtain at least one first subblock, and perform, by column, block division on input data of a to-be-multiplied second matrix at a granularity of a subblock whose scale is N×R, to obtain at least one second subblock, where all M, N, and R are positive integers; determine one or more target subblock combinations, where each target subblock combination includes one first subblock and one second subblock, and at least one element in the first subblock and at least one element in the second subblock in each target subblock combination are to-be-multiplied elements; and input each of the one or more target subblock combinations into the matrix computing apparatus.

The matrix computing apparatus is configured to compute a product result of the first subblock and the second subblock based on the input to-be-multiplied elements in the first subblock and the second subblock in each target subblock combination.

According to a fourth aspect, this application further provides a computing apparatus. The apparatus includes a processor, a memory, and a matrix computing apparatus. The processor executes program instructions in the memory to perform the method according to any one of the first aspect and the possible implementations of the first aspect. The memory is coupled to the processor, and stores program instructions and data that are necessary for performing a data backup process. The matrix computing apparatus is configured to implement the functions of the matrix computing apparatus according to the second aspect.

According to a fifth aspect, this application further provides a computing apparatus. The computing apparatus includes a processor, a memory, and a matrix computing apparatus. The processor performs the method according to any one of the first aspect and the possible implementations of the first aspect, or performs the method according to any one of the second aspect and the possible implementations of the second aspect, or performs the method according to any one of the third aspect and the possible implementations of the third aspect. A communication interface is configured to communicate with another device.

**BRIEF DESCRIPTION OF DRAWINGS**

FIG. 1 is a diagram of a compressed sparse row format;
FIG. 2 is a diagram of a compressed sparse column format;
FIG. 3 is a diagram of a structure of a matrix accelerator;
FIG. 4 is a schematic flowchart of a structured pruning algorithm;
FIG. 5 is a diagram of an application scenario of a graph neural network;
FIG. 6 is a schematic flowchart corresponding to a matrix computing method according to an embodiment of this application;
FIG. 7 is an instance of a matrix computing method according to an embodiment of this application;
FIG. 8 is a diagram of a structure of a matrix computing apparatus 10 according to an embodiment of this application;
FIG. 9 is a diagram of a structure of a matrix computing apparatus 10 according to an embodiment of this application;
FIG. 10 is a diagram of a structure of another matrix computing apparatus 10 according to an embodiment of this application;
FIG. 11 is a schematic flowchart of performing a subblock multiplication operation based on a matrix computing apparatus 10 according to an embodiment of this application; and
FIG. 12 is a diagram of a structure of a computing device according to an embodiment of this application.

**DESCRIPTION OF EMBODIMENTS**

To better explain embodiments of this application, related terms or technologies in this application are first explained.

**1. Row vector**

The row vector is a $1\times m$ matrix, where m is any positive integer, for example, $x=[x_1\ x_2\ ...x_m]$.

**2. Column vector**

The column vector is an $n\times 1$ matrix, where n is any positive integer, for example,

$$x=\begin{bmatrix} x_1 \\ x_2 \\ ... \\ x_n \end{bmatrix}.$$

**3. Matrix size/scale**

An $m\times n$ matrix is a rectangular array formed by arranging m rows and n columns of elements. For example,

$$A=\begin{bmatrix} A_{11} & A_{12} & ... & A_{1n} \\ A_{21} & A_{22} & ... & A_{2n} \\ ... & ... & ... & ... \\ A_{m1} & A_{m2} & ... & A_{mn} \end{bmatrix}.$$

Each number that constitutes the matrix is referred to as an element of the matrix. For example, all $A_{11}$, $A_{12}$, and $A_{mn}$ are elements of the matrix A. A subscript (or referred to as coordinates) of the element indicates a location, in the matrix, of the element, and may be a row number (or referred to as a row coordinate) and a column number (or referred to as a column coordinate), in the matrix, of the element. For example, $A_{11}$ indicates that the element is located in a 1st row and a 1st column of the matrix A, and $A_{21}$ indicates that the element is located in a 2nd row and the 1st column of the matrix A. In addition, the subscript may alternatively be in a different representation form. For example, $A_{11}$ may alternatively be written as $A_{1,1}$, and $A_{21}$ may alternatively be written as $A_{2,1}$. A similar part is not described again in the following.

### 4. Matrix addition (matrix addition)

The matrix addition means adding two matrices with a same scale (or referred to as a same size, where to be specific, the two matrices have a same quantity of rows (rows) and a same quantity of columns (columns)). Certainly, a matrix subtraction may alternatively be performed. Specifically, addition or subtraction is performed on elements at a same location in each of the two matrices. In the following, A and B are each an m×n matrix, and A+B=a matrix C.

$$A=\begin{bmatrix} A_{11} & A_{12} & ... & A_{1n} \\ A_{21} & A_{22} & ... & A_{2n} \\ ... & ... & ... & ... \\ A_{m1} & A_{m2} & ... & A_{mn} \end{bmatrix} \quad B=\begin{bmatrix} B_{11} & B_{12} & ... & B_{1n} \\ B_{21} & B_{22} & ... & B_{2n} \\ ... & ... & ... & ... \\ B_{m1} & B_{m2} & ... & B_{mn} \end{bmatrix}$$

$$C=A+B=\begin{bmatrix} A_{11}+B_{11} & A_{12}+B_{12} & ... & A_{1n}+B_{1n} \\ A_{21}+B_{21} & A_{22}+B_{22} & ... & A_{2n}+B_{2n} \\ ... & ... & ... & ... \\ A_{m1}+B_{m1} & A_{m2}+B_{m2} & ... & A_{mn}+B_{mn} \end{bmatrix}$$

### 4. Matrix multiplication (matrix multiplication)

For two to-be-multiplied matrices (for example, matrices A and B), it is required that a quantity of columns of A is the same as a quantity of rows of B. For example, if A is an m×n matrix and B is an n×r matrix, a product of A and B is an m×r matrix. For example,

$$A=\begin{bmatrix} a_{11} & a_{12} & a_{13} \\ a_{21} & a_{22} & a_{23} \end{bmatrix}, \quad B=\begin{bmatrix} b_{11} & b_{12} \\ b_{21} & b_{22} \\ b_{31} & b_{32} \end{bmatrix},$$

and

$$C=AB=\begin{bmatrix} a_{11}b_{11}+a_{12}b_{21}+a_{13}b_{31} & a_{11}b_{12}+a_{12}b_{22}+a_{13}b_{32} \\ a_{21}b_{11}+a_{22}b_{21}+a_{23}b_{31} & a_{21}b_{12}+a_{22}b_{22}+a_{23}b_{32} \end{bmatrix}.$$

### 5. Sparse matrix (sparse matrix)/dense matrix (dense matrix)

A matrix is classified as the sparse matrix or the dense matrix based on a proportion of a non-zero element (Number of Non-zero Element) in the matrix. If most elements in the matrix are non-zero elements, the matrix is the dense matrix. On the contrary, if most elements in the matrix are zero, the matrix is the sparse matrix. Spareness is used to reflect the proportion of the non-zero element in the sparse matrix. Higher spareness indicates a lower proportion of the non-zero element. The following is an example of a sparse matrix.

| 0 | 7 | 0 | 0 | 0 | 0 | 6 |
|---|---|---|---|---|---|---|
| 0 | 7 | 6 | 3 | 0 | 4 | 0 |
| 0 | 4 | 3 | 0 | 0 | 0 | 0 |
| 4 | 2 | 0 | 0 | 0 | 0 | 0 |
| 0 | 0 | 0 | 0 | 3 | 2 | 4 |

A large matrix requires a large-capacity internal storage for storage, but most elements in a sparse matrix are 0. Therefore, when a computer stores and operates the sparse matrix, an element of the sparse matrix is usually coded as a sparse code. The sparse code includes only information about a non-zero element. Internal storage costs of operating the sparse matrix are reduced by storing the sparse code of the sparse matrix. Common formats of the sparse code include a coordinate (coordinate, COO) format, a compressed sparse row (compressed sparse row, CSR) format, and a compressed sparse column (compressed sparse column, CSC) format.

(1) In the coordinate COO format, the sparse matrix is represented by using a triplet. The triplet includes a row number, a column number, and an element value. The row number and the column number identify a location of the element value. The following shows a simple sparse matrix for description.

| 1 | 0 | 0 |
|---|---|---|
| 0 | 0 | 6 |
| 3 | 0 | 0 |

For the sparse matrix, the following information may be stored in a format of (values, row, column):

(1, 1, 1), where a value of an element is 1, and a subscript of the element is (1, 1);
(3, 3, 1), where a value of an element is 3, and a subscript of the element is (3, 1); and
(6, 2, 3), where a value of an element is 6, and a subscript of the element is (2, 3).

Certainly, the foregoing information may alternatively be stored in another format, for example, (row, column, values). This is not specifically limited.

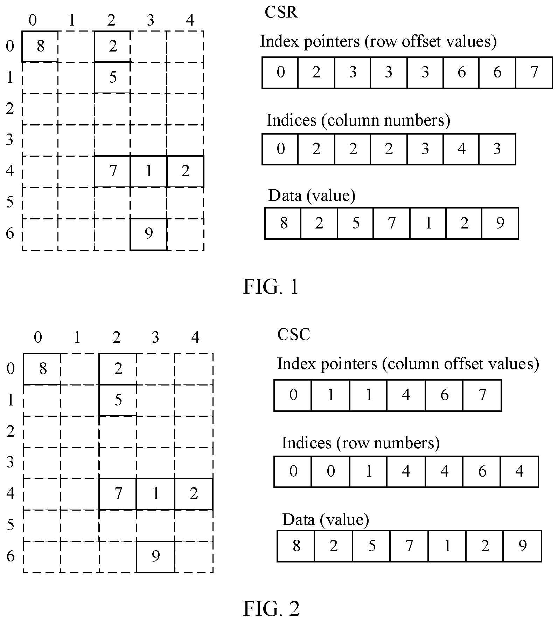

(2) In the compressed sparse row CSR format, the sparse matrix is represented by using three types of data. The three types of data are respectively an element value, a column number, and a row offset value. A difference between the CSR and the COO lies in that the row offset value is used instead of the row number. FIG. 1 shows an example of a compressed sparse row format.

(3) In the compressed sparse column CSC format, the sparse matrix is represented by using three types of data. The three types of data are respectively an element value, a row number, and a column offset value. A difference between the CSC and the COO lies in that the column offset value is used instead of the column number. FIG. 2 shows an example of a compressed sparse row format.

The foregoing describes three compression formats of the sparse matrix. Correspondingly, a matrix in an uncompressed format is generally referred to as a dense matrix. The dense matrix includes only a value of a matrix element, but coordinates of the element are not stored.

**6. Multiply accumulate (multiply accumulate, MAC) operation**

The multiply accumulate operation is a special operation in a digital signal processor or some microprocessors, for example, a matrix multiplication operation or a matrix addition operation. A hardware circuit unit that implements the operation is referred to as a "multiplier-accumulator". This operation is to add a product result of a multiplication to a value of the accumulator, and then store an obtained result in the accumulator.

**7. Arithmetic intensity (arithmetic intensity, AI) operation**

The arithmetic intensity operation means a ratio of work W to internal storage traffic Q, that is, AI=W/Q, where Q indicates a quantity of operations per byte of internal storage traffic. When the work W is expressed as FLOPs, an obtained arithmetic intensity AI is a ratio (FLOPs/Byte) of a floating-point operation to a total data movement amount (FLOPs/Byte). A higher value of the AI indicates a higher data reuse rate.

### 8. Structured sparsity/unstructured sparsity

Structured sparsity/unstructured sparsity is used to describe a distribution of zero elements in a matrix. Structured sparsity indicates that the distribution of the zero elements is even. It may be understood that, in a row vector per unit length in the matrix, structured sparsity means that a proportion of a zero element is the same. On the contrary, if a distribution of zero elements is random and uneven, the distribution is unstructured sparsity.

The following is an example of a matrix with structured sparsity. For example, a unit length is $1\times6$, and each row vector includes two non-zero elements.

| 0 | 7 | 0 | 0 | 0 | 8 |
|---|---|---|---|---|---|
| 0 | 0 | 6 | 3 | 0 | 0 |
| 5 | 0 | 0 | 0 | 7 | 0 |
| 4 | 0 | 0 | 9 | 0 | 0 |
| 0 | 0 | 5 | 0 | 3 | 0 |

The following shows a matrix with unstructured sparsity. Zero values of the matrix are generally distributed randomly and unevenly.

| 0 | 7 | 0 | 4 | 0 | 8 |
|---|---|---|---|---|---|
| 1 | 4 | 0 | 0 | 0 | 0 |
| 0 | 3 | 0 | 0 | 7 | 0 |
| 4 | 0 | 1 | 9 | 0 | 2 |
| 3 | 0 | 5 | 0 | 3 | 0 |

### 9. Neural network

The neural network (neural network, NN) is an algorithmic mathematical model that imitates a behavior feature of an animal neural network and performs distributed parallel information processing. Information is processed by adjusting an interconnection relationship between a large quantity of nodes in the neural network.

Specifically, the neural network may usually include a plurality of layers, for example, a convolution layer, a fully connected layer (fully connected layer, FC), an activation layer, and a pooling layer, that are connected in a head-to-tail mode. Each layer may be expressed as a function $y = f_w(x)$, where f is a function of the function. A derivative may be solved for the function f, w is a weight (or referred to as a weight matrix), x is an input (or referred to as an input matrix), and y is an output (or referred to as an output matrix). It should be understood that one layer of the neural network may include a plurality of neurons, and weight values of the plurality of neurons may be combined into one weight matrix. It can be learned that the neural network usually internally includes a large amount of matrix computing.

Matrix computing is an important computing type like neural network convolution computing in artificial intelligence computing, simultaneous equation solving in scientific computing, or algebraic graph computing. In an early phase, a general-purpose CPU is used for computing. In recent years, chip vendors provide various matrix accelerators to improve matrix computing power of a chip.

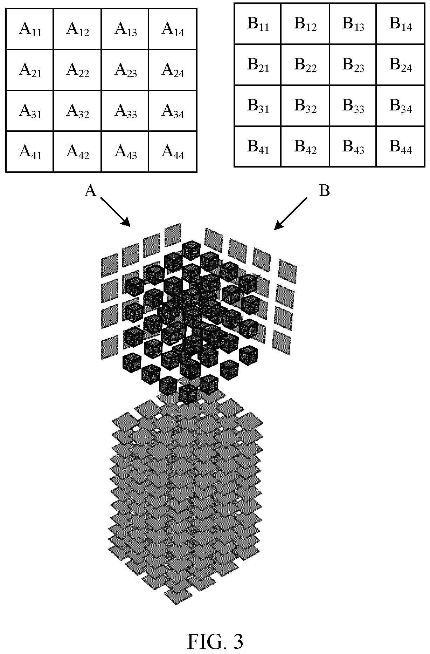

FIG. 3 is a diagram of a hardware structure of a matrix accelerator. As shown in FIG. 3, the matrix accelerator includes 64 MACs. In a unit time cycle, the matrix accelerator can complete a multiplication operation of a $4\times4$ matrix A and a $4\times4$ matrix B, to obtain a product result matrix C. Each MAC performs the multiplication operation on input values of two elements at fixed locations in two matrices. This matrix accelerator can usually effectively accelerate computing of a dense matrix.

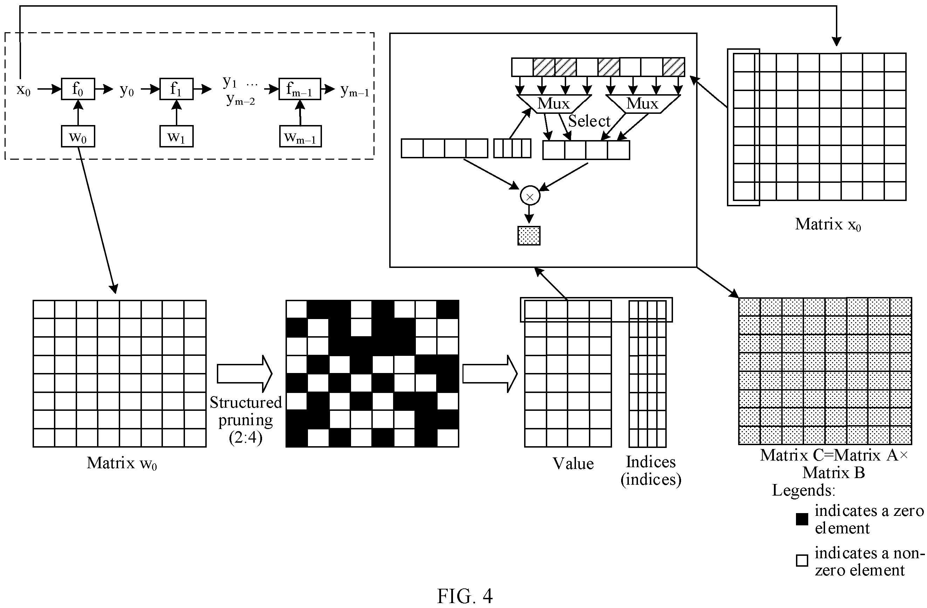

With emergence of the matrix accelerators, some algorithms for improving computing efficiency, for example, a pruning algorithm, also become research focuses. Currently, some matrix accelerators allow using the pruning algorithm to accelerate computing of a specific type of sparse matrix. FIG. 4 shows a scenario of accelerating a matrix operation with reference to the pruning algorithm.

First, a structure of a neural network shown in FIG. 4 is described. The neural network may include m layers that are connected in a head-to-tail mode, where m is an integer greater than or equal to 2. Each layer may be expressed as a function $y = f_w(x)$. A $0^{th}$ layer of the neural network may be expressed as a function $f_0$, where for $f_0$, input data is a matrix $x_0$, a weight matrix is a matrix $w_0$, and an output matrix is a matrix $y_0$, for example, $f_0 = x_0 \cdot w_0 = y_0$; a $1^{st}$ layer of the neural network may be expressed as a function $f_1$, where for $f_1$, an input matrix is $y_0$, an output matrix is $y_1$, and a weight matrix is $w_1$, for example, $f_1 = y_0 \cdot w_1 = y_1$; and so on.

One layer is used as an example. If the neural network is used to process an image or video frame, the matrix $x_0$ may be obtained by converting a frame of to-be-processed image or a frame of image in the to-be-processed video. A person skilled in the art may know that the matrix $x_0$ is usually a dense matrix. A weight matrix, for example, the matrix $w_0$, includes values of weights that are trained at the $0^{th}$ layer of the neural network. A range of the value of the weight is generally (0, 1]. In other words, the matrix $w_0$ is also a dense matrix. It can be learned that the neural network internally includes a large quantity of matrix multiplication operations.

The following uses a computing process of the function $f_0 = x_0 \cdot w_0$ as an example to describe an acceleration procedure of multiplication computing of the matrix. As shown in FIG. 4, both sizes of the matrix $x_0$ and the matrix $w_0$ are $8 \times 8$.

(1) A structured pruning algorithm is used to prune the matrix $w_0$ in a fixed proportion, for example, 2:4. Values of weights (elements) in each $1 \times 4$ row vector are sorted. Two weights with smaller values in the weights are removed, and values of the two weights are set to 0. As shown in FIG. 4, after structured pruning, the matrix $w_0$ is a structured sparse matrix, and a scale of a pruned matrix $w_0$ is $4 \times 8$.

(2) A row vector (denoted as a first row vector) corresponding to a $1^{st}$ row of the compressed matrix $w_0$ is extracted. Four elements are selected by using two data selectors (mux) from a column vector (denoted as a first column vector) corresponding to a $1^{st}$ column of the matrix $x_0$, to obtain a $4 \times 1$ column vector.

(3) A product of the $1 \times 4$ first row vector of the compressed matrix $w_0$ and the $4 \times 1$ column vector obtained by using the data selector are computed by using a matrix accelerator, where a product result is an element in the matrix $y_0$.

Another element in the matrix $y_0$ is obtained according to steps (1) to (3).

The matrix accelerator removes 50% of zero elements with reference to the pruning algorithm, to double computing efficiency.

Unstructured pruning (unstructured pruning) corresponds to structured pruning. In the foregoing example, during unstructured pruning, values of all elements in the matrix $w_0$ may be sorted, and 50% of elements with smaller values in all the elements are removed. It is clear that unstructured pruning may bring higher accuracy, but a pruned matrix is usually an unstructured sparse matrix. A current matrix accelerator supports only acceleration of a structured sparse matrix, but does not support acceleration of an unstructured sparse matrix. In addition, it should be noted that the matrix accelerator that supports computing of the structured sparse matrix can be applied only to a limited scenario (for example, convolution computing of a neural network). This is because, in the multiplication operation of the matrix shown in FIG. 4, only a weight matrix can be pruned, but an input matrix cannot be pruned. If the input matrix is pruned, accuracy of a product result of the input matrix cannot be ensured, and an error of a computing result may be increased.

Therefore, currently, in an application scenario of a graph (Graph) computing neural network, namely, a graph neural network (Graph Neural Network), an existing matrix accelerator is completely inapplicable. This is because an input matrix of the graph neural network usually includes a large-scale sparse matrix, and has very high spareness and a proportion of non-zero elements that is usually less than 1%. The current matrix accelerator cannot effectively accelerate a computing scenario of this sparse matrix, and only software can be used to complete computing of the sparse matrix.

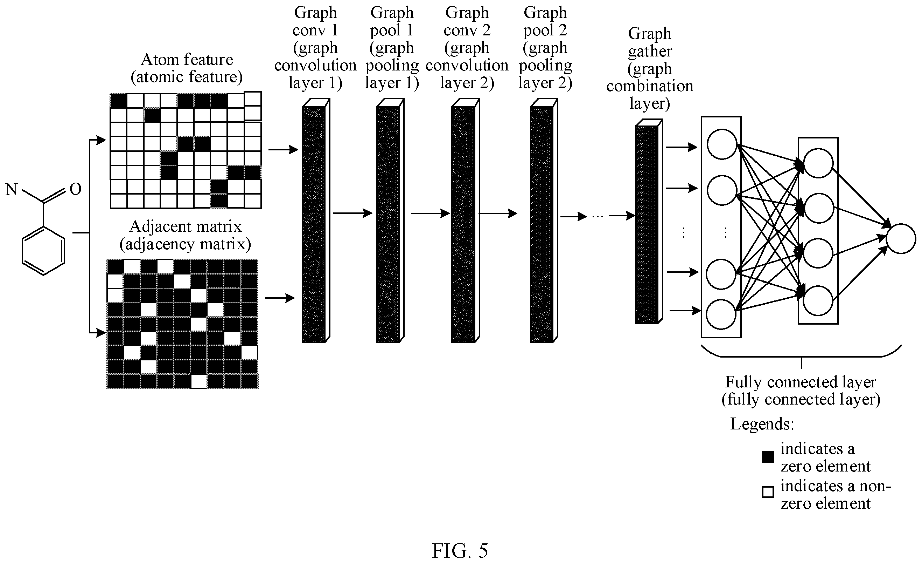

The graph neural network is widely used in many fields such as chemical molecular structures, gene sequencing, social networks, recommendation systems, and natural languages. For example, FIG. 5 is an application scenario of the graph neural network. The graph neural network is used to analyze a chemical molecular structure. The molecular structure shown in FIG. 5 includes nine atoms. An atom feature is an input matrix used to describe an atomic feature. Each column in the input matrix is a feature vector of an atom. An adjacency matrix is another input matrix used to describe a connection relationship between atoms. An element value that is 1 indicates that two atoms have a connection relationship. An element value that is 0 indicates that two atoms do not have a connection relationship. It can be learned that the atom feature matrix is a dense matrix, and the adjacency matrix is a sparse matrix and has high sparseness. Because the existing matrix accelerator cannot accelerate a computing scenario of this sparse matrix, currently, only the software can be used to complete computing of the sparse matrix. As a result, performance of the graph neural network is greatly different from that of a general graph neural network, and is dozens of times behind.

In conclusion, the existing matrix accelerator can support only dense matrix-matrix multiplication (GEMM) computing, or double a speed of computing of the specific type of sparse matrix with reference to the structured pruning algorithm, but cannot satisfy all pruning algorithms, and cannot support sparse general matrix-matrix multiplication (SpGEMM) computing in an unstructured pruning algorithm, graph computing, the graph neural network, scientific computing (HPC), and the like. In addition, a scenario in which the existing matrix accelerator can be used is excessively limited, most sparse matrix multiplication operations need to be completed by the software, and a computing speed is slow, resulting in lagging development of application technologies in many fields.

The following describes in detail a matrix computing method provided in embodiments of this application.

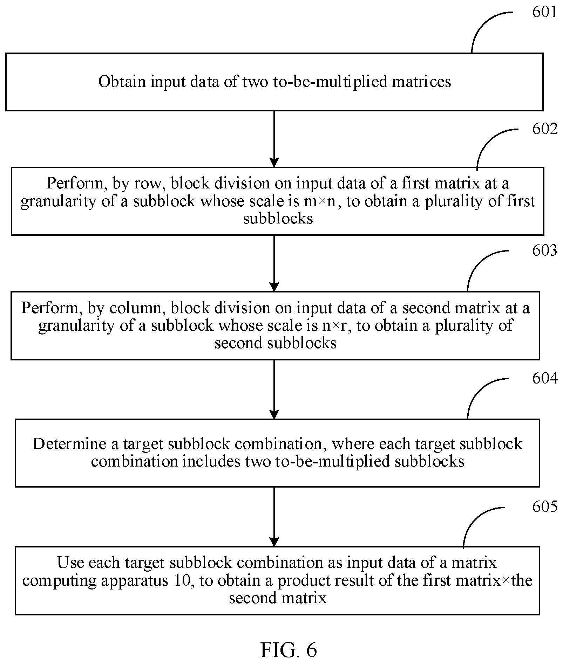

FIG. 6 is a schematic flowchart of a matrix computing method according to an embodiment of this application. As shown in FIG. 6, the method includes the following steps.

Step 601: Obtain input data of two to-be-multiplied matrices (denoted as a first matrix and a second matrix).

The first matrix may be a sparse matrix or a dense matrix, and the second matrix may be a sparse matrix or a dense matrix. In other words, the matrix computing method provided in this application may be used to compute a dense matrix×a dense matrix, a sparse matrix×a dense matrix, and a sparse matrix×a sparse matrix.

The following uses the sparse matrix (the first matrix)×the sparse matrix (the second matrix) as an example to describe in detail the matrix computing method. The input data of the first matrix includes a set of a value of a non-zero element in the first matrix and location information (for example, denoted as original coordinates/original subscripts, which is not described again in the following) indicating a location of the non-zero element in the first matrix. For example, the input data of the first matrix is a sparse code of the first matrix. A format of the sparse code may be any compressed sparse format, for example, a CSR format, a CSC format, or a COO format. Similarly, the input data of the second matrix includes a set of a value of a non-zero element in the second matrix and location information indicating a location of the non-zero element in the second matrix. For example, the input data of the second matrix is a sparse code of the second matrix. A format of the sparse code may be the any compressed sparse format, for example, the CSR format, the CSC format, or the COO format.

Step 602: Perform, by row, block division on the input data of the first matrix at a granularity of a subblock whose scale is m×n, to obtain a plurality of subblocks (for example, first subblocks). Herein, m and n each are a positive integer, and m may be equal to n.

A representation (denoted as a first compressed matrix) that is obtained by compressing the first matrix by row may be obtained based on the input data of the first matrix. For clarity, the following uses the first compressed matrix to demonstrate how to perform block division.

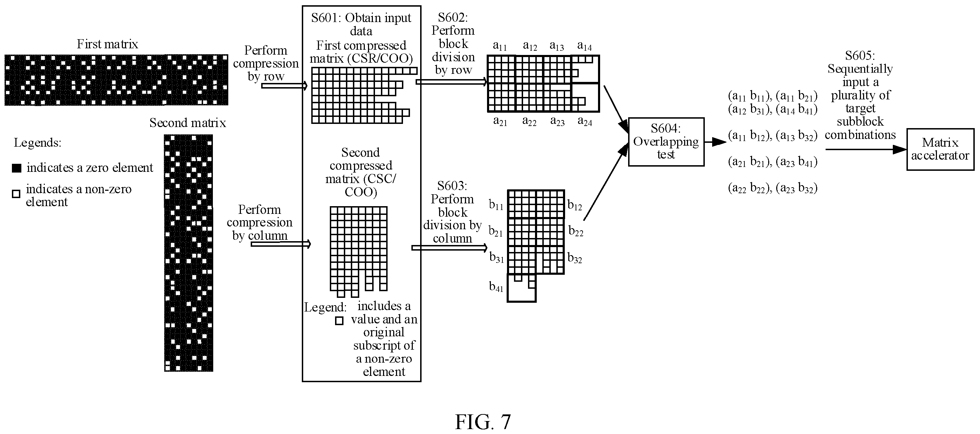

With reference to FIG. 7 for understanding. FIG. 7 shows an example of a process of obtaining the first compressed matrix by compressing (compressing to remove a zero element) the first matrix by row. The first compressed matrix may represent a state in which non-zero elements in the first matrix are arranged by row. For example, in the first compressed matrix shown in FIG. 7, elements in a same row have a same row number, and quantities of elements in different rows may not be equal, which is related to a quantity of non-zero elements included in each row of the first matrix. It should be noted that a row number herein is a row number, in the first matrix, of the non-zero element. Similarly, a column number of the non-zero element is a column number, in the first matrix, of the non-zero element. In addition, it should be noted that a quantity of rows of the first compressed matrix is less than or equal to a quantity of rows of the first matrix. For example, when one or more rows of all-zero elements exist in the first matrix, the one or more rows of all-zero elements are compressed by entire row. In this case, the quantity of rows of the first compressed matrix is less than the quantity of rows of the first matrix. If at least one non-zero element exists in each row of the first matrix, the quantity of rows of the first compressed matrix is equal to the quantity of rows of the first matrix. A matrix computing manner provided in this application is not affected by this case.

For example, it is assumed that block division is performed on the first compressed matrix by row at a granularity of a 4×4 subblock. As shown in FIG. 7, after block division, eight first subblocks are obtained. For example, the eight first subblocks are respectively marked as a11, a12, a13, a14, a21, a22, a23, and a24 based on a row-column relationship between the subblocks. Herein, aij indicates that the subblock is located in an $i^{th}$ horizontal rank (or an $i^{th}$ row) and a $j^{th}$ vertical rank (or a $j^{th}$ column) in the first compressed matrix. As shown in FIG. 7, a11, a12, a13, and a14 are subblocks located in a $1^{st}$ row in the first compressed matrix, and a21, a22, a23, and a24 are subblocks located in a $2^{nd}$ row of the first compressed matrix. During block division, if a quantity of elements at a boundary in the first compressed matrix is less than 4×4 (for example, a13, a14, a23, and a24), zeros are added to reach 4×4. Data of each subblock includes a matrix formed by the subblock and location information indicating a location, in the first matrix, of a non-zero element in the matrix.

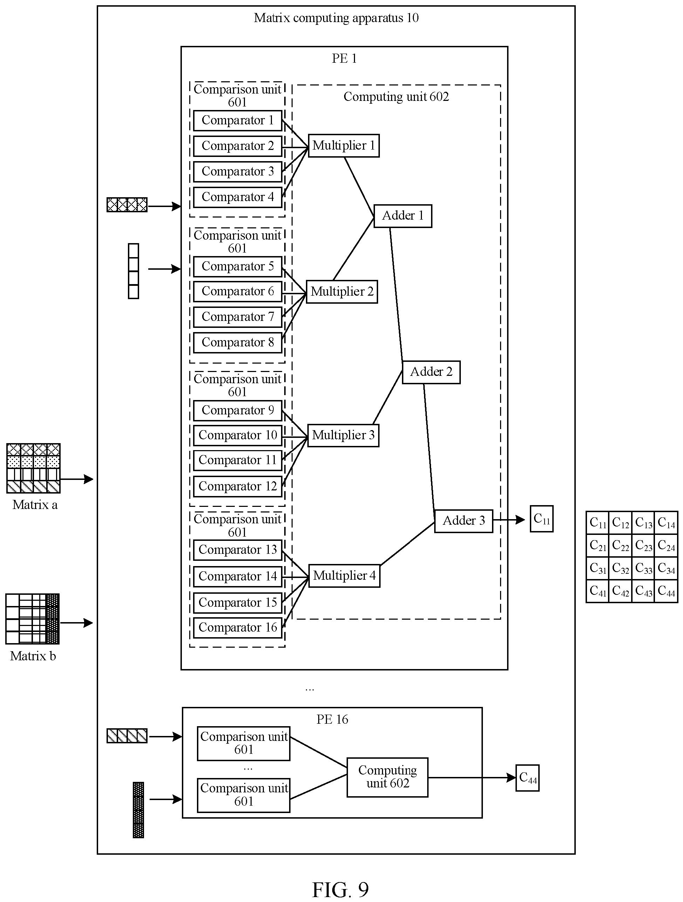

It should be noted that the first compressed matrix in FIG. 9 is merely a structure shown for easy of understanding "block division". During actual application, the sparse code of the first matrix may be stored in a memory (for example, an internal storage). In this application, block division may be directly performed based on the sparse code of the first matrix in the CSR or COO format. If the input data of the first matrix is the sparse code in the CSC format, the input data may be first converted into the sparse code in the COO or CSR format, and then block division is performed.

Step 603: Perform, by column, block division on the input data of the second matrix at a granularity of a subblock whose scale is n×r, to obtain a plurality of subblocks (for example, second subblocks). Herein, n and r each are a positive integer, and n may be equal to r.

A representation (denoted as a second compressed matrix) that is obtained by compressing the second matrix by column may be obtained based on the input data of the second matrix. For clarity, the following uses the second compressed matrix to demonstrate how to perform block division.

Still refer to FIG. 7. FIG. 7 shows an example of a process of obtaining the second compressed matrix by compressing (compressing to remove a zero element) the second matrix by column. The second compressed matrix may represent a state in which non-zero elements in the second matrix are arranged by column. For example, in the second compressed matrix shown in FIG. 7, elements in a same column have a same column number, but quantities of elements in different columns may not be equal, which is related to a quantity of non-zero elements in each column of the second matrix. It should be noted that a column number herein is a column number, in the second matrix, of the non-zero element. Similarly, a row number of the non-zero element is a row number, in the second matrix, of the non-zero element. In addition, it should be noted that a quantity of columns of the second compressed matrix is less than or equal to a quantity of columns of the second matrix. For example, when one or more columns of all-zero elements exist in the second matrix, the one or more columns are compressed by entire column. In this case, the quantity of columns of the second compressed matrix is less than the quantity of columns of the second matrix. If at least one non-zero element exists in each column of the second matrix, the quantity of columns of the second compressed matrix is equal to the quantity of columns of the second matrix. The matrix computing manner provided in this application is not affected by this case.

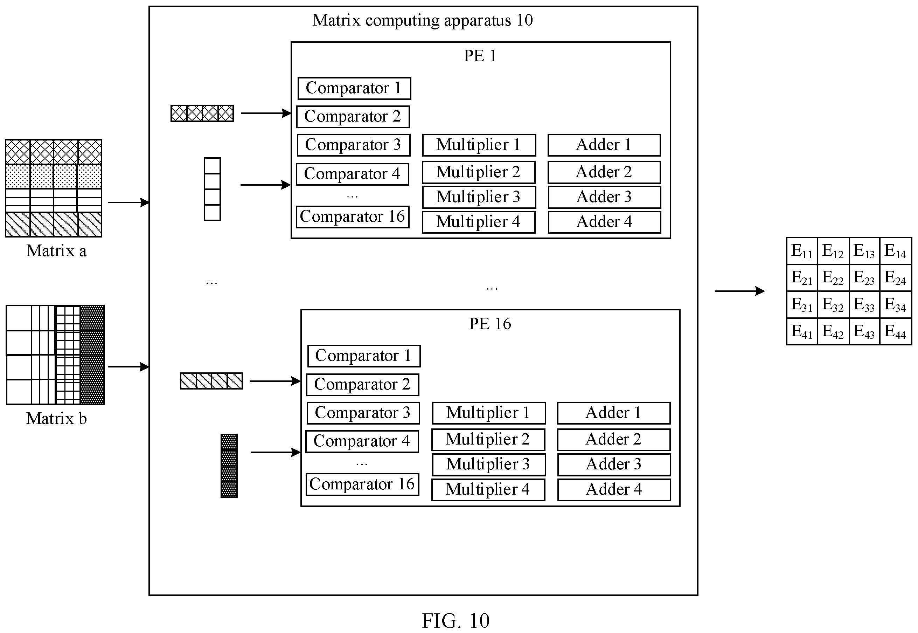

For example, it is assumed that block division is performed by column at a granularity of a $4 \times 4$ subblock on the second compressed matrix shown in FIG. 7. As shown in FIG. 7, after block division, seventh second subblocks are obtained. For example, the seven second subblocks are respectively marked as b11, b21, b31, b41, b12, b22, and b32 based on a row-column relationship between the subblocks. Herein, buv indicates that the subblock is located in a $u^{th}$ horizontal rank (or a $u^{th}$ row) and a $v^{th}$ vertical rank (or a $v^{th}$ column) in the second compressed matrix. As shown in FIG. 10, b11, b21, b31, and b41 are subblocks located in a $1^{st}$ column of the second compressed matrix, and b12, b22, and b32 are subblocks located in a $2^{nd}$ column of the second compressed matrix.

It should be noted that the second compressed matrix in FIG. 7 is merely a structure shown for easy of understanding "block division". During actual application, the sparse code of the second matrix may be stored in the memory (for example, the internal storage). In this application, block division may be directly performed based on the sparse code of the second matrix in the CSC or COO format. If the input data of the second matrix is the sparse code in the CSR format, the input data may be first converted into the sparse code in the COO or CSC format, and then block division is performed.

In an optional implementation solution, it may be agreed that, when the two to-be-multiplied sparse matrices are coded, the sparse code of the first matrix is in the CSR or COO format, and sparse code of the second matrix is in the CSC or COO format. In this way, block division can be performed more conveniently and quickly.

It should be noted that: (1) Both the subblock scales shown in FIG. 7 are examples, and the two subblock scales each may be another value, for example, m=n=r=8, that is, both the two subblocks scales are $8 \times 8$, or m=n=r=16, that is, both the two subblocks scales are $16 \times 16$, or m=4, n=8, and r=10, that is, the subblock scale of the first subblock in FIG. 7 may be $4 \times 8$, the subblock size of the second subblock is $8 \times 10$. This is not limited in this application. (2) Names of each first subblock and each second subblock obtained through block division are merely examples. A naming rule of the first subblock and the second subblock is not limited in this application. The eight first subblocks in FIG. 7 may be further sequentially numbered as a1, a2, ..., and a8, or the like in a row sequence. The seven second subblocks in FIG. 7 may be further sequentially numbered as b1, b2, ..., and b7, or the like in a column sequence. (3) There is no strict time sequence limitation between step 602 and step 603. Step 602 may be performed before step 603, or step 603 may be performed before step 602, or step 602 and step 603 are performed at the same time. This is not limited in this application. This is also true for other similar steps related to two matrices. Details are not described in the following.

Step 604: Detect whether any first subblock overlaps any second subblock, to determine one or more target subblock combinations, where each target subblock combination includes a to-be-multiplied first subblock and a to-be-multiplied second subblock.

A plurality of subblock combinations may be obtained through division based on the subblocks in the first compressed matrix and the subblocks in the second compressed matrix. Each subblock combination includes one first subblock and one second subblock. For the plurality of subblock combinations, whether two subblocks in each subblock combination overlap is sequentially detected. If the two subblocks in each subblock combination overlap, the subblock combination is the target subblock combination.

Still refer to FIG. 7. For example, one subblock is selected from the first compressed matrix (a11, a12, a13, a14, a21, a22, a23, a24), and one subblock is selected from the second compressed matrix (b11, b21, b31, b41, b12, b22, b32), to constitute one subblock combination. In a permutation and combination manner, $8 \times 7=56$ subblock combinations may be obtained, for example, (a11 and b11), (a11 and b21), (a11 and b31), (a11 and b41), (a12 and b11), (a12 and b21), (a12 and b31), (a12 and b41), (a13 and b11), (a13 and b21). (a13 and b31), (a13 and b41), (a14 and b11), (a14 and b21), (a14 and b31), (a14 and b41), and so on. For the plurality of subblock combinations, whether two subblocks in each subblock combination overlap is sequentially detected. For example, whether a11 overlaps b11 is detected, whether a11 overlaps b21 is detected, whether a11 overlaps b31 is detected, whether a11 overlaps b41 is detected, and so on. "Overlap" means that the two subblocks include at least one group of overlapping elements. For example, if a column number of an element in a11 is the same as a row number of an element in b11, the two elements are overlapping elements, it may be further determined that a11 overlaps b11. To be specific, (a11 and b11) is one target subblock combination.

For the foregoing overlapping test, in an implementation, the element in a11 may be compared with the element in b11 one by one, to detect whether a11 overlaps b11. In an implementation scenario of this application, in this manner, a

EP 4 546 173 A1

maximum of 16×16 comparisons are performed. Detection may be stopped when it is detected that overlapping elements exist in a11 and b11. If all elements of the two subblocks do not overlap after 16×16 comparisons are performed, the two subblocks do not overlap, that is, the subblock combination is not the target subblock combination.

In the foregoing manner, a large quantity of comparisons may be required. For example, each subblock combination requires 16×16 comparisons. When scales of the subblocks are large, a large quantity of computing power and internal storage resources are required to complete detection.

Therefore, an embodiment of this application provides another overlapping test method, to reduce computing power and internal storage overheads. Herein, a11 and b11 are still used as examples. The method includes: obtaining a largest column number and a smallest column number of elements in a11, and denoting the largest column number and the smallest row number as a first column number range; obtaining a largest row number and a smallest row number of elements in b11, and denoting the largest row number and the smallest row number as a first row number range; and if an intersection exists between the first column number range and the first row number range, determining that a11 overlaps b11; or if no intersection exists between the first column number range and the first row number range, determining that a11 does not overlap b11. In this manner, other subblock combinations are sequentially detected. Details are not described herein again. In this manner, a test procedure can be greatly simplified, overheads such as the computing power and an internal storage can be reduced, test duration can be shortened, and a matrix operation velocity can be improved.

For example, the overlapping test method may be performed by software, or may be performed by hardware. The hardware that implements the method may also be referred to as a detection module. For example, the detection module may include at least four selectors. Two of the four selectors are respectively configured to record a smallest column number value and a largest column number value in input data of a first subblock. The other two selectors are respectively configured to record a smallest row number value and a largest row number value in input data of the second subblock.

One or more groups of target subblock combinations are determined in the foregoing manner. As shown in FIG. 7, a plurality of target subblock combinations determined through overlapping detection include (a11 and b11), (a11 and b21), (a12 and b31), (a14 and b41), (a11 and b12), (a13 and b32), (a21 and b21), (a23 and b41), (a22 and b22), and (a23 and b32). Each group of target subblock combinations includes two to-be-multiplied subblocks.

Step 605: Sequentially use the target subblock combinations as input data of a matrix computing apparatus (or referred to as a matrix accelerator) 10, to obtain a product result of the first matrix×the second matrix.

An embodiment of this application provides a matrix computing apparatus 10. The matrix computing apparatus 10 may support a sparse matrix×a sparse matrix, a dense matrix×a dense matrix, and a dense matrix×a sparse matrix. In this application, the matrix computing apparatus 10 may be configured to compute a product result of a first subblock and a second subblock in each target subblock combination.

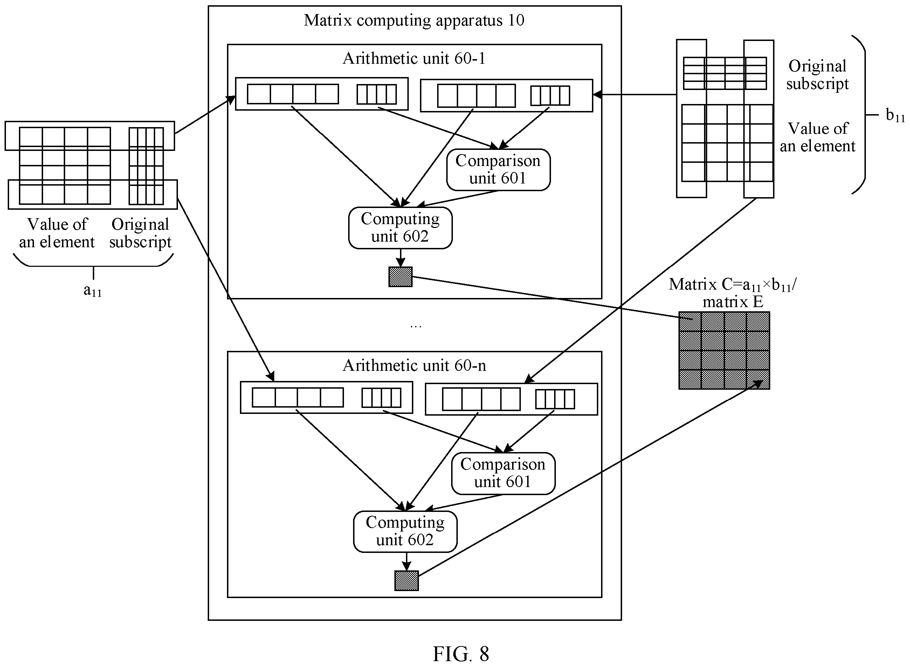

The following first describes a structure of the matrix computing apparatus 10 with reference to FIG. 8.

FIG. 8 is a diagram of the structure of the matrix computing apparatus 10 according to an embodiment of this application. It is assumed that input data of the matrix computing apparatus 10 includes input data (a 4×4 matrix a11 as an example shown in FIG. 8, but not limited thereto) of a to-be-multiplied m×n matrix a and input data (a 4×4 matrix b11 shown as an example in FIG. 8, but not limited thereto) of an n×r matrix b. Functionally, the matrix computing apparatus may be configured to compute a product result of the m×n matrix a and the n×r matrix b. The input data of the matrix a includes a value of each element in the matrix a and location information (for example, an original subscript in FIG. 8) of a non-zero element. The location information indicates a location, in an original matrix (for example, a first matrix), of the non-zero element. Similarly, the input data of the matrix b includes a value of each element in the matrix b and location information of a non-zero element. The location information indicates a location, in an original matrix (for example, a second matrix), of the non-zero element. For ease of description, the following uses an example in which the location information includes a row number and a column number in the original subscript of an element for description.

Structurally, as shown in FIG. 8, the matrix computing apparatus 10 includes one or more arithmetic units (processing elements, PEs) 60. Each arithmetic unit 60 includes one or more comparison units 601 (FIG. 8 shows only one comparison unit 601, but this application is not limited thereto) and one or more computing units 602 (FIG. 8 shows only one computing unit 602, but this application is not limited thereto). One arithmetic unit 60 may be configured to compute a vector inner product of a row vector in the matrix a and a column vector in the matrix b. The vector inner product is an element in the product result matrix C of the matrix a×the matrix b.

One arithmetic unit is used as an example. One comparison unit 601 may be configured to compare two pieces of data. In this application, the comparison unit 601 may be configured to compare location information of two elements. The two elements may be any element in the input row vector and any element in the input column vector. The comparison unit 601 may include at least one comparator, and the at least one comparator may perform a function of the comparison unit 601.

The computing unit 602 is configured to compute the vector inner product based on a comparison result of the comparison unit 601 and the input row vector and the input column vector. The computing unit 602 may include one or more multipliers and one or more adders. The one or more multipliers and the one or more adders may perform a function of the computing unit 602.

12

In an example, it is assumed that the input data of the matrix computing apparatus 10 includes the m×n matrix a and the n×r matrix b. In other words, functionally, the matrix accelerator may be configured to perform a matrix multiplication operation on the m×n matrix a and the n×r matrix b. Structurally, for example, the matrix computing apparatus 10 may include m×r arithmetic units 60. Each arithmetic unit 60 may include n×n comparators, n multipliers, and n/n-1 adders.

With reference to the example shown in FIG. 7, it is assumed that m=n=r=4, that is, the input data of the matrix computing apparatus 10 includes input data of a to-be-multiplied 4×4 matrix and input data of a 4×4 matrix b.

For example, structurally, as shown in FIG. 9, the matrix computing apparatus 10 may include 16 PEs (denoted as a PE 1, a PE 2, a PE 3, ..., and a PE 16). Each PE is configured to perform a multiply-add operation on a 1×4 row vector in the matrix a and a 4×1 column vector in the matrix b. For example, the PE 1 is configured to compute a first row vector of the matrix a and a first column vector of the matrix b; the PE 2 is configured to compute the first row vector of the matrix a and a second column vector of the matrix b; the PE 3 is configured to compute the first row vector of the matrix a and a third column vector of the matrix b; the PE 4 is configured to compute the first row vector of the matrix a and a fourth column vector of the matrix b; the PE 5 is configured to compute a second row vector of the matrix a and a first column vector of the matrix b; and by analogy, the PE 16 is configured to compute a fourth row vector of the matrix a and a fourth column vector of the matrix b.

The following uses the PE 1 as an example to describe in detail a computing process of a multiplication operation ($\vec{p} \times \vec{q}$) of the first row vector (for example, denoted as $\vec{p}$) of the matrix a and the first column vector (for example, denoted as $\vec{q}$) of the matrix b.

Specifically, input data of $\vec{p}$ includes values (denoted as p1, p2, p3, and p4) of four elements of $\vec{p}$ and an original subscript (for example, a row number and a column number) of each non-zero element in the four elements. Input data of $\vec{q}$ includes values (denoted as q1, q2, q3, and q4) of four elements of $\vec{q}$ and an original subscript (for example, a row number and a column number) of each non-zero element in the four elements.

For example, the PE 1 may include 16 comparators, which are respectively denoted as a comparator 1, a comparator 2, ..., and a comparator 16. Each comparator is configured to compare coordinates of a group of elements, and each group of elements includes one element in $\vec{p}$ and one element in $\vec{q}$. For example, the comparator 1 is configured to compare a column number of an element p1 with a row number of an element q1; the comparator 2 is configured to compare the column number of the element p1 with a row number of an element q2; the comparator 3 is configured to compare the column number of the element p1 with a row number of an element q3; the comparator 4 is configured to compare the column number of the element p1 with a row number of an element q4; the comparator 5 is configured to compare a column number of an element p2 with the row number of the element q1; the comparator 6 is configured to compare the column number of the element p2 with the row number of the element q2; and by analogy, the comparator 16 is configured to compare a column number of an element p4 with a row number of an element q4.

If the compared column number and row number are the same, the two elements overlap (denoted as a group of overlapping elements). If the compared column number and row number are not the same, the two elements do not overlap. Based on the design of this application, a maximum of four groups of overlapping elements can be selected by using the 16 comparators. It is assumed that the four groups of overlapping elements are respectively (p1 and q1), (p2 and q2), (p3 and q3), and (p4 and q4). In this case, $\vec{p} \times \vec{q}$=p1·q1+p2·q2+p3·q3+p4·q4=c11.

In an example, refer to FIG. 9. The PE 1 includes four multipliers (for example, respectively denoted as a MAC 1, a MAC 2, a MAC 3, and a MAC 4) and three adders. Each multiplier is configured to compute a product of one group of overlapping elements. For example, the MAC 1 may be configured to compute p1·q1, the MAC 2 may be configured to compute p2·q2, the MAC 3 is configured to compute p3·q3, and the MAC 4 is used to compute p4·q4. The three adders are configured to add products of the MAC 1, the MAC 2, the MAC 3, and the MAC 4, to obtain that c11=p1·q1+p2·q2+p3·q3+p4·q4. In other words, an addition result is a value of c11. Herein, c11 is an element in a product result (referred to as a result for short) matrix c of a×b, and represents an element in a 1st row and a 1st column in the result matrix c.

Similarly, the PE 2 (not shown in FIG. 9) is configured to compute a product of the first row vector in the matrix a and the second column vector in the matrix b, to obtain c12. The PE 3 (not shown in FIG. 9) is configured to compute a product of the first row vector in the matrix a and the third column vector in the matrix b, to obtain c13. The PE 4 (not shown in FIG. 9) is configured to compute a product of the first row vector in the matrix a and the fourth column vector in the matrix b, to obtain c13. The PE 5 (not shown in FIG. 9) is configured to compute a product of the second row vector in the matrix a and the first column vector in the matrix b, to obtain c21. By analogy, the PE 16 is configured to compute a product of the fourth row vector in the matrix a and the fourth column vector in the matrix b, to obtain c21. In this way, the result matrix c of the matrix a and the matrix b is obtained.

It should be noted that, in the PE 1 shown in FIG. 9, a manner of connecting the comparators, a manner of connecting the comparator to the multiplier, and a manner of connecting the multiplier to the adder are merely examples. This is not limited in embodiments of this application. Any connection manner in which a vector inner product in embodiments of this application can be computed is applicable to the matrix computing apparatus 10.

In another example, refer to FIG. 10. In FIG. 10, on a basis of FIG. 9, one adder is added to each PE. The PE 1 is still used as an example. The PE 1 in FIG. 10 includes four multipliers and four adders. The four multipliers and the four adders are configured to: perform $p1 \cdot q1 + p2 \cdot q2 + p3 \cdot q3 + p4 \cdot q4 + E11$ (E11 is an element in a $1^{st}$ row and a $1^{st}$ column in the accumulator E)=c11+E11=E11', and write E11' back to E11. Similarly, the PE 2 is configured to: compute c12+E12=E12', and write E121' back to E12,

the PE 3 is configured to: compute c13+E13=E13', and write E13' back to E13,
the PE 4 is configured to: compute c14+E14=E14', and write E14' back to E14,
the PE 5 is configured to: compute c21+E21=E21', and write E21' back to E21,
the PE 6 is configured to: compute c22+E22=E22', and write E22' back to E22,
the PE 7 is configured to: compute c23+E24=E23', and write E23' back to E23,
and so on, to determine a result matrix E' of (a result matrix c of a11×b11+the accumulator E), and write the result matrix E' back to the accumulator E. It should be noted that, if an initial value of the accumulator E is 0, the result matrix E' is the result matrix c.

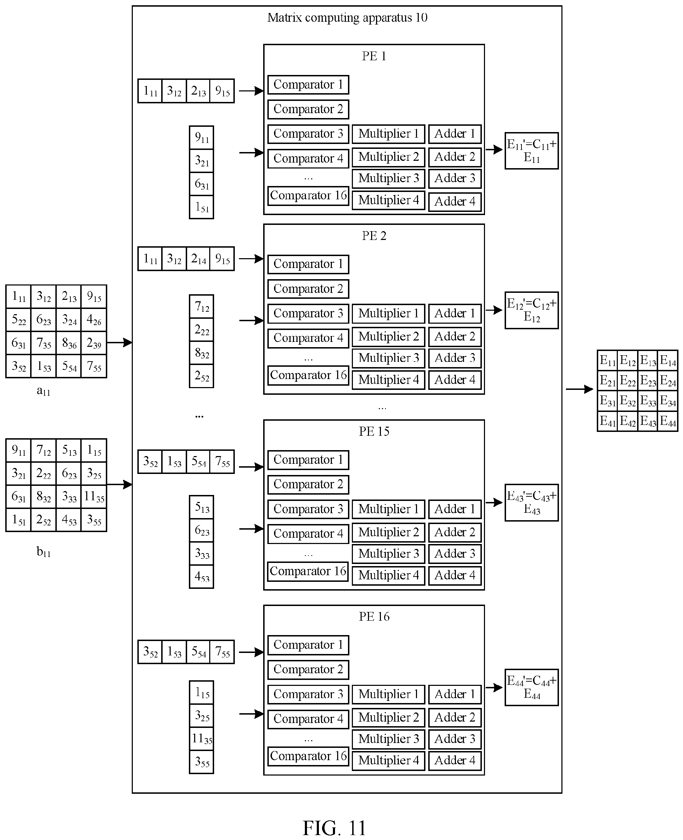

For example, FIG. 11 shows an example of a11×b11. For example, it is assumed that input data of a11 is a sparse code in a COO format, that is, the input data of a11 includes a value and a (an original) subscript of an element. It is assumed that input data of b11 is a sparse code in the COO format, and the input data of b11 includes a (an original) subscript of an element. It can be learned that elements in a same row in a11 have a same row number, and elements in a same column in b11 have a same column number.

Refer to FIG. 11. For example, the PE 1 receives input data of a first row vector of a11 and input data of a first column vector of b11. The PE 2 receives the input data of the first row vector of a11 and input data of a second column vector of b11. The PE 3 receives the input data of the first row vector of a11 and input data of a third column vector of b11. By analogy, the PE 15 receives input data of a fourth row vector of a11 and input data of a third column vector of b11. The PE 16 receives the input data of the fourth row vector of a11 and input data of a fourth column vector of b11.

The PE 1 is used as an example. For example, the comparator 1 is configured to compare whether a column number in 111 is the same as a row number in 911. The comparator 1 is configured to compare whether the column number in 111 is the same as a row number in 321. The comparator 3 is configured to compare whether the column number in 111 is the same as a row number in 631. The comparator 4 is configured to compare whether the column number in 111 is the same as a row number in 151. The comparator 5 is configured to compare whether a column number in 312 is the same as the row number in 911. By analogy, the comparator 16 is configured to compare whether a column number in 915 is the same as a row number in 151.

It may be determined, by using the comparator 1 to the comparator 16, that (111, 911) is a pair of overlapping elements, (312, 321) is a pair of overlapping elements, (213, 631) is a pair of overlapping elements, and (915, 151) is a pair of overlapping elements.

A pair of overlapping elements is input into a multiplier. The multiplier computes a product of the overlapping elements. For example, a multiplier 1 performs 1×9=9, a multiplier 2 performs 3×3=9, a multiplier 3 performs 2×6=12, and a multiplier 4 performs 9×1=9=C11.

It is assumed that all elements in an accumulation matrix E in this case are 0. C11+E11=9+9+12+9+0=39 is performed by using the four adders.

The PE 2 to the PE 16 perform the same operation based on respective input data, to obtain the accumulation matrix E. Because an initial value of the accumulation matrix E is 0, the accumulation matrix E herein is the product result matrix C of a11×b11. It should be noted that, because subscript data of each corresponding element in the product result matrix c is the same as subscript data of each corresponding element in the accumulation matrix E stored in the accumulator, as dense matrices are added, values of elements at each same location in each of the product result matrix C and the accumulation matrix E may be directly added herein in a point-to-point manner.

The matrix computing apparatus 10 may be configured to perform a multiplication operation on two subblocks in each target subblock combination, to accelerate a sparse matrix multiplication operation.

The following uses the matrix computing apparatus 10 shown in FIG. 10 as an example to describe a specific performing process of step 605.

With reference to the plurality of target subblock combinations determined in FIG. 7, in an example, the plurality of target subblock combinations may be divided into a plurality of sets. Each set includes one or more target subblock combinations. For example, division may be performed based on a location of the subblock. A plurality of first subblocks in a plurality of target subblock combinations in a same set are located in a same row (in the first compressed matrix), and a plurality of second subblocks in the plurality of target subblock combinations are located in a same column (in the second compressed matrix).

For example, with reference to the example in FIG. 7, the plurality of target subblock combinations include (a11 and b11), (a11 and b21), (a12 and b31), (a14 and b41), (a11 and b12), (a13 and b32), (a21 and b21), (a23 and b41), (a22 and b22), and (a23 and b32). The plurality of target subblock combinations may be divided into a set 1, a set 2, a set 3, and a set 4. The set 1 includes (a11 and b11), (a11 and b21), (a12 and b31), and (a14 and b41). The set 2 includes (a11 and b12) and (a13 and b32). The set 3 includes (a21 and b21) and (a23 and b41). The set 4 includes (a22 and b22) and (a23 and b32).

The one or more target subblock combinations in each set are sequentially input into the matrix computing apparatus at a granularity of a set. It should be understood that "sequentially input" herein is not limited to input in an arrangement sequence of the target subblock combinations, but means that one target subblock combination is selected each time and input into the matrix computing apparatus 10 until all the target subblock combinations in the set are input. An input sequence of a plurality of target subblock combinations in a set is not limited in this application. For example, for the set 1, when one target subblock combination is input in one beat, (a11 and b11) may be input before (a11 and b21), or (a11 and b21) may be input before (a11 and b11). Another set is similar. Details are not described herein again.

In the following, a product matrix of the first matrix× the second matrix is denoted as a matrix Z. The matrix Z includes one or more subblocks. Zst represents a subblock located in an $s^{th}$ row (horizontal rank) and a $t^{th}$ column (vertical rank) in the matrix Z. For the target subblock combination, for example, a complete computing process of the matrix computing apparatus 10 is as follows.

For the set 1: $\sum a_{1j} \times b_{u1}$=a11×b11+a11×b21+a12×b31+a14×b41=Z11.

(1) First, a11 and b11 are input into the matrix computing apparatus 10, and the matrix computing apparatus 10 computes a11×b11+E (the accumulated matrix E, where an initial value is 0), to obtain a result matrix E1, and writes the result matrix E1 back to the accumulator E.

(2) a11 and b21 are input into the matrix computing apparatus 10, and the matrix computing apparatus 10 computes a11×b21+E (which is E1 in this case), to obtain a result matrix E2, and writes the result matrix E2 back to the accumulator E.

(3) a12 and b31 are input into the matrix computing apparatus 10, and the matrix computing apparatus 10 computes a12×b31+E (which is E2 in this case), to obtain a result matrix E3, and writes the result matrix E3 back to the accumulator E.

(4) a14 and 41 are input into the matrix computing apparatus 10, and the matrix computing apparatus 10 computes a14×b41+E (which is E3 in this case), to obtain a result matrix E4, and writes the result matrix E4 back to the accumulator E.

In this case, the result matrix E4=a11×b11+a11×b21+a12×b31+a14×b41=Z11. Data Z11 stored in the accumulator E is read.

For the set 2: $\sum a_{1j} \times b_{u2}$=a11×b12+a13×b32=Z12.

After computing of the previous set is completed, the accumulator E is initialized, and the accumulator E is initialized to 0.

(1) First, a11 and b12 are input into the matrix computing apparatus 10, and the matrix computing apparatus 10 computes a11×b12+E (an initial value is 0), to obtain a result matrix E5, and writes the result matrix E5 back to the accumulator E.

(2) a13 and b32 are input into the matrix computing apparatus 10, and the matrix computing apparatus 10 computes a13×b32+E (an initial value is E5), to obtain a result matrix E6, and writes the result matrix E6 back to the accumulator E.

The result matrix E6=a11×b12+a13×b32=Z12. Data Z12 stored in the accumulator E is read.

For the set 3: $\sum a_{2j} \times b_{u1}$=a21×b12+a23×b41=Z21.

The accumulator E is initialized, and the accumulator E is initialized to 0.

(1) First, a21 and b12 are input into the matrix computing apparatus 10, and the matrix computing apparatus 10 computes a21×b12+E (an initial value is 0), to obtain a result matrix E7, and writes the result matrix E7 back to the accumulator E.

(2) a23 and b41 are input into the matrix computing apparatus 10, and the matrix computing apparatus 10 computes a23×b41+E (an initial value is E7), to obtain a result matrix E8, and writes the result matrix E8 back to the accumulator E.

The result matrix E8=a21×b12+a23×b41=Z21. Data Z21 stored in the accumulator E is read.

For the set 4: $\sum a_{2j} \times b_{u2}$=a22×b22+a23×b32=Z22.

The accumulator E is initialized, and the accumulator E is initialized to 0.

(1) First, a22 and b22 are input into the matrix computing apparatus 10, and the matrix computing apparatus 10 computes a22×b22+E (an initial value is 0), to obtain a result matrix E9, and writes the result matrix E9 back to the accumulator E.

(2) a23 and b32 are input into the matrix computing apparatus 10, and the matrix computing apparatus 10 computes a23×b32+E (an initial value is E9), to obtain a result matrix E10, and writes the result matrix E10 back to the accumulator E.

The result matrix E10=a22×b22+a23×b32=Z22. Data Z22 stored in the accumulator E is read.

In this way, the product result of the first matrix and the second matrix, namely, the matrix Z, is obtained.

$$Z = \begin{bmatrix} z_{11} & z_{12} \\ z_{21} & z_{22} \end{bmatrix}.$$

It should be noted that data of each subblock in the product result matrix Z includes a value of an element in the subblock and location information of the element. The location information indicates a location, in the actual product result matrix of the first matrix and the second matrix. For example, the matrix Z may be a sparse code in any compressed sparse format.

All the matrix computing apparatuses 10 shown in FIG. 9 to FIG. 11 can complete a multiplication operation of a 4×4 matrix and a 4×4 matrix in a unit time cycle (which is usually referred to as a beat by a person skilled in the art).

It should be noted that the structures of the matrix computing apparatuses 10 shown in FIG. 9 to FIG. 11 are merely examples. A relationship between a scale of an input matrix and a quantity of arithmetic units and a relationship between the scale of the input matrix and a quantity of comparators, a quantity of multipliers, and a quantity of adders in one arithmetic unit are not limited in this application. A quantity of PEs of the matrix computing apparatus 10 may be less than 16, or a quantity of comparators in one PE may be less than 16, or the like. A multiplication operation of matrix and another matrix that have a same specification may be completed in one or more beats.

For example, when a matrix scale of the input data remains unchanged, the matrix accelerator in embodiments of this application may alternatively be a matrix computing apparatus 20. The matrix computing apparatus 20 includes 16 PEs. Each PE may include 12 comparators, four multipliers, and four adders. If the matrix computing apparatus 10 can complete a multiplication operation of the 4×4 matrix a and the 4×4 matrix b in one beat, with support of an algorithm, the matrix computing apparatus 20 may also complete a multiply-add operation of the 4×4 matrix a and the 4×4 matrix b in one beat. For another example, this application provides another matrix computing apparatus 30. The matrix computing apparatus 30 may include eight PEs. Each PE includes 16 comparators, four multipliers, and four adders. If the matrix computing apparatus 10 completes a multiplication operation of the 4×4 matrix a and the 4×4 matrix b in one beat, the matrix computing apparatus 30 may complete the multiplication operation of the matrix a and the matrix b in two beats. Certainly, the structures of the matrix computing apparatus 20 and the matrix computing apparatus 30 are also examples. This is not limited in this application. In an actual product, the matrix computing apparatus may further have more or fewer components than those of the matrix computing apparatuses 10 shown in FIG. 9 to FIG. 11. For example, the matrix computing apparatus in this application may further have an input interface, a register, the foregoing detection module, and a gating circuit. This is not limited in this application.

In addition, it should be noted that, a matrix-matrix multiplication operation is completed by one matrix computing apparatus 10. In an embodiment of this application, a plurality of matrix computing apparatuses with a same specification or different specifications are further supported to jointly complete one matrix-matrix multiplication operation. For example, four matrix computing apparatuses 10 with a same specification are configured to perform parallel computing on Z11, Z12, Z21, and Z22, to further improve computing efficiency. The plurality of matrix computing apparatuses 10 may be located in a same computing device, for example, may be located in a same chip, or may be located in different chips of a same computing device. Alternatively, the plurality of matrix computing apparatuses 10 may be located in different computing devices. This is not specifically limited.

The foregoing describes a method procedure of the sparse matrix×the sparse matrix. The matrix computing method provided in this application may be further applied to a dense matrix×a sparse matrix. For example, when the dense matrix×the sparse matrix is accelerated, the dense matrix may not be compressed, block division may be directly performed on the dense matrix, and location information of an element is assigned. Location information of an element in each subblock indicates a location, in the dense matrix, of the element. In other words, coordinates of elements in the subblock of the dense matrix are continuous. Alternatively, the dense matrix may be compressed. For example, an element of the dense matrix is coded as a sparse code. This is not specifically limited. Another procedure is the same as that of the sparse matrix×the sparse matrix. Details are not described herein again.

In addition, the foregoing shows an example in which the matrix computing apparatus 10 performs sparse matrix-matrix multiplication. The general-purpose matrix computing apparatus 10 provided in embodiments of this application not only supports sparse matrix-matrix multiplication, but also supports sparse matrix-vector multiplication (the input data is a matrix and a vector), sparse vector-vector multiplication (the input data is two vectors), and existing dense matrix-matrix multiplication GEMM.

For example, for a sparse matrix-vector multiplication instruction, during block division, block division may be performed on the first matrix by row on a scale of a 4×4 subblock, and block division may be on the second matrix by column at a granularity of a 4×1 subblock. For a subsequent procedure, refer to the foregoing descriptions. Details are not described herein again.

For another example, block division may alternatively be performed on the first matrix by row on a scale of a 4×4 subblock, block division may alternatively be performed on the second matrix by column at the granularity of the 4×4 subblock, and subblock-subblock multiplication may be computed according to the sparse matrix-vector multiplication instruction. Herein, a11×b11 is used as an example. For example, after it is determined that a11 and b11 are the target subblock combination, input data of a matrix computing apparatus 40 may be a11 and a column vector of b11, and the matrix computing apparatus 40 completes a multiplication operation on a11 and the column vector of b11 in one beat. Alternatively, the input data may be one row vector of a11 and b11, and the matrix computing apparatus 40 completes a multiplication operation on the row vector of a11 and b11 in one beat. In an optional manner, after it is detected that a11 and b11 are the target subblock combination, whether a11 overlaps the column vector of b11 may be further detected. If a11 overlaps the column vector of b11, a11 and the column vector of b11 are input to the matrix computing apparatus 40. If a11 does not overlap the column vector of b11, a11 and the column vector of b11 are not input into the matrix computing apparatus 40. For an overlapping detection method, refer to the foregoing descriptions. Details are not described herein again.

A structure of the matrix computing apparatus 40 may be the same as the structure of the matrix computing apparatus 10 shown in FIG. 10, or may be another structure. For example, the matrix computing apparatus 40 includes four PEs.

Similarly, the foregoing computing process may alternatively be completed according to a vector-vector multiplication instruction. Details are not described herein again.

For a dense matrix×a dense matrix, the matrix computing apparatus in embodiments of this application may further include a gating circuit. The gating circuit controls a connection and a disconnection of the comparator. When the dense matrix×the dense matrix is computed, the comparator may be disabled, and input data is directly sent to the multiplier, to complete a multiplication operation of the dense matrix×the dense matrix. It should be noted that the input data of the dense matrix includes only a value of an element, but does not include location information of the element. In other words, the matrix computing apparatus provided in this application is a general-purpose matrix computing apparatus, and may be used in various scenarios.

Based on the foregoing design, a multiplication operation of a sparse matrix that has any spareness, and has a random distribution of non-zero elements can be effectively accelerated. In addition, computing efficiency and accuracy can be further improved with reference to an unstructured pruning technology. Typical sparse matrix multiplication operations such as a graph neural network, algebraic graph computing, and multigrid solving can be effectively accelerated, and more application scenarios can be covered.

In addition, in the foregoing solution, two N×N subblocks are input into the matrix computing apparatus 10 in each beat. The matrix accelerator 10 may complete N3 pieces of multiplication computing and N3 pieces of addition computing in each beat. An arithmetic intensity I=(N3+N3)/(N×N)×2=N (flops/word) of the matrix computing apparatus 10 may be computed. Based on this design, the matrix computing apparatus 10 provided in this application can increase the arithmetic intensity for a sparse matrix-matrix multiplication element by N times. In other words, each piece of data may be reused for N times. This can greatly reduce storage space and access bandwidth that are required for sparse matrix computing, reduce huge bandwidth required for conventional matrix multiplication, greatly improve the arithmetic intensity (AI), can efficiently prepare data required for sparse matrix computing, and can improve utilization of the matrix computing apparatus.

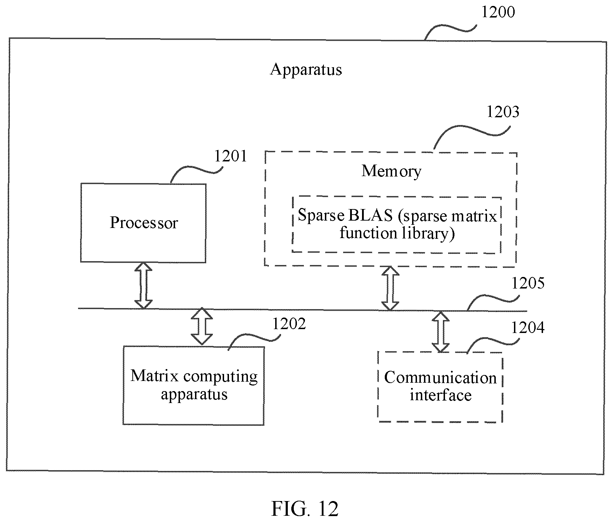

FIG. 12 is a diagram of a computing device according to this application. The device may perform the method in the embodiment shown in FIG. 6. The device 1200 includes a processor 1201. Optionally, the device 1200 may further include a memory 1203 and a matrix computing apparatus 1202. Optionally, the device 1200 may further include a communication interface 1204. The processor 1201, the memory 1203, the matrix computing apparatus 1202, and the communication interface 1204 may be connected to each other through a communication line 1205. The communication line 1205 may be a peripheral component interconnect (peripheral component interconnect, PCI for short) bus, an extended industry standard architecture (extended industry standard architecture, EISA for short) bus, or the like. The communication line 1205 may be classified into an address bus, a data bus, a control bus, and the like. For ease of representation, only one thick line is used to represent the bus in FIG. 12, but this does not mean that there is only one bus or only one type of bus.

The processor 1201 may be a CPU, a microprocessor, an ASIC, or one or more integrated circuits configured to control program execution in the solutions of this application. In an example, the processor 1201 may perform step 601 to step 603 in the method embodiment in FIG. 6, and optionally, may be further configured to perform step 604. For details, refer to the foregoing descriptions of the steps. Details are not described herein again.

The communication interface 1204 is any apparatus like a transceiver, and is configured to communicate with another device or a communication network like an ethernet, a radio access network (radio access network, RAN), a wireless local area network (wireless local area network, WLAN), or a wired access network, for example, obtain input data of two to-be-multiplied matrices.

The memory 1203 may be a ROM, another type of static storage device that can store static information and instructions, a RAM, or another type of dynamic storage device that can store information and instructions, or may be an electrically erasable programmable read-only memory (electrically erasable programmable read-only memory, EEPROM), a compact disc read-only memory (compact disc read-only memory, CD-ROM) or another optical disk storage, an optical disc storage (including a compact optical disc, a laser disc, an optical disc, a digital versatile disc, a Blu-ray disc, and the like), a magnetic disk storage medium or another magnetic storage device, or any other medium that can be accessed by a computer and that can be configured to carry or store expected program code in a form of an instruction or a data structure, but is not limited thereto. The memory may exist independently, and is connected to the processor through the communication line 1205. The memory may alternatively be integrated with the processor.

The memory 1203 is configured to store computer-executable instructions used to perform the solutions of this application, and the processor 1201 controls execution. The processor 1201 is configured to execute the computer-executable instructions stored in the memory 1203, to implement the matrix computing method provided in the foregoing embodiments of this application.

The memory 1203 may further store a sparse matrix function library (spares blas). The function library may include instructions used to implement the embodiment in FIG. 6, including but not limited to one or more of the following: a block division instruction (refer to the descriptions of step 602 or step 603, where details are not described herein again), an overlapping test instruction (refer to the descriptions of step 604, where details are not described herein again), a sparse matrix-matrix multiplication instruction, a sparse matrix-vector multiplication instruction, and a vector-vector multiplication instruction. Optionally, the memory 1203 may further store source code for implementing any instruction or function in the function library.

The matrix computing apparatus 1202 is configured to implement the functions of the matrix computing apparatus in the method embodiment shown in FIG. 6, and is configured to accelerate a sparse matrix multiplication operation. Refer to the descriptions of step 605 in the method embodiment in FIG. 6. Details are not described herein again.

An embodiment of this application further provides a computer program product including instructions. The computer program product may be a software or program product that includes instructions and that can run on a computing device or be stored in any usable medium. When the computer program product runs on at least one computer device, the at least one computer device is enabled to perform the method performed by the processor 1201 in the apparatus in FIG. 12. For details, refer to the foregoing related descriptions. Details are not described herein again.

An embodiment of this application further provides a computer-readable storage medium. The computer-readable storage medium may be any usable medium that can be stored by a computing device, or a data storage device that includes one or more usable media. The usable medium may be a magnetic medium (for example, a floppy disk, a hard disk, or a magnetic tape), an optical medium (for example, a DVD), a semiconductor medium (for example, a solid state disk), or the like. The computer-readable storage medium includes instructions. The instructions instruct the computing device to perform the method performed by the processor 1201 in the apparatus in FIG. 12. For details, refer to the foregoing related descriptions. Details are not described herein again.

Optionally, the computer-executable instructions in this embodiment of this application may also be referred to as application program code. This is not specifically limited in embodiments of this application.

The part implemented by the software in the foregoing embodiments may be completely or partially implemented in a form of a computer program product. The computer program product includes one or more computer instructions. When the computer program instructions are loaded and executed on a computer, the procedure or functions according to embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by a computer, or a data storage device like a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (Solid State Disk, SSD)), or the like.

The various illustrative logical units and circuits described in embodiments of this application may implement or operate the described functions by using a general-purpose processor, a digital signal processor, an application-specific integrated circuit (ASIC), a field programmable gate array (FPGA) or another programmable logical apparatus, a discrete gate or transistor logic, a discrete hardware component, or a design of any combination thereof. The general-purpose processor may be a microprocessor. Optionally, the general-purpose processor may also be any conventional processor, controller, microcontroller, or state machine. The processor may alternatively be implemented by a combination of computing apparatuses such as a digital signal processor and a microprocessor, a plurality of microprocessors, one or more microprocessors in combination with a digital signal processor core, or any other similar configuration.

The steps of the methods or the algorithms described in embodiments of this application may be directly embedded in hardware, a software unit executed by a processor, or a combination thereof. The software unit may be stored in a RAM memory, a flash memory, a ROM memory, an EPROM memory, an EEPROM memory, a register, a hard disk, a removable magnetic disk, a CD-ROM, or a storage medium in any other form in the art. For example, the storage medium may be connected to a processor, so that the processor may read information from the storage medium and write information to the storage medium. Optionally, the storage medium may be further integrated into the processor. The processor and the storage media may be disposed in an ASIC.

These computer program instructions may alternatively be loaded onto a computer or another programmable data processing device, so that a series of operations and steps are performed on the computer or the another programmable device, to generate computer-implemented processing. In this way, the instructions executed on the computer or the another programmable device provide steps used to implement a specified function in one or more procedures in a flowchart and/or a specified function in one or more blocks in a block diagram.

Although this application is described with reference to specific features and embodiments thereof, it is clear that various modifications and combinations may be made to them without departing from the spirit and scope of this application. Correspondingly, this specification and the accompanying drawings are merely example descriptions of this application defined by the appended claims, and are considered as any or all of modifications, variations, combinations or equivalents that cover the scope of this application. It is clear that a person skilled in the art can make various modifications and variations to this application without departing from the scope of this application. This application is intended to cover these modifications and variations of this application provided that they fall within the scope of protection defined by the following claims and their equivalent technologies.

**Claims**

1. A matrix computing method, comprising:

   performing, by row, block division on input data of a to-be-multiplied first matrix at a granularity of a subblock whose scale is M×N, to obtain at least one first subblock; and performing, by column, block division on input data of a to-be-multiplied second matrix at a granularity of a subblock whose scale is N×R, to obtain at least one second subblock, wherein all M, N, and R are positive integers;
   determining one or more target subblock combinations, wherein each target subblock combination comprises one first subblock and one second subblock, and at least one element in the first subblock and at least one element in the second subblock in each target subblock combination are to-be-multiplied elements; and
   using each of the one or more target subblock combinations as input data of a matrix computing apparatus, to obtain a product result of the first matrix and the second matrix that is output by the matrix computing apparatus.

2. The method according to claim 1, wherein the first matrix is a sparse matrix, the input data of the first matrix comprises a value of a non-zero element of the first matrix and location information of the non-zero element, and the location information indicates a location of the non-zero element in the first matrix; and
   the second matrix is a dense matrix, the input data of the second matrix comprises a value of an element of the second matrix and location information of the element, and the location information indicates a location of the element in the second matrix.

3. The method according to claim 1, wherein the first matrix is a sparse matrix, the input data of the first matrix comprises a value of a non-zero element of the first matrix and location information of the non-zero element, and the location information indicates a location of the non-zero element in the first matrix; and
   the second matrix is a sparse matrix, the input data of the second matrix comprises a value of a non-zero element of the second matrix and location information of the non-zero element, and the location information indicates a location of the non-zero element in the second matrix.

4. The method according to any one of claims 1 to 3, wherein the input data of the first matrix is a sparse code of the first matrix, and the sparse code is obtained by coding an element in the first matrix.

5. The method according to claim 4, wherein a format of the sparse code comprises a compressed sparse row CSR format and a coordinate COO format.

6. The method according to any one of claims 1 to 5, wherein if the second matrix is a sparse matrix, the input data of the second matrix is a sparse code of the second matrix, and the sparse code is obtained by coding an element in the second matrix.

7. The method according to claim 6, wherein a format of the sparse code comprises the compressed sparse column CSC format and the coordinate COO format.

8. The method according to any one of claims 2 to 7, wherein the location information indicates a row number and a column number of the non-zero element, and the to-be-multiplied element means that a column number of an element in the first subblock is the same as a row number of an element in the second subblock.

9. The method according to any one of claims 2 to 8, wherein the determining one or more target subblock combinations comprises:

dividing the at least one first subblock and the at least one second subblock into a plurality of subblock combinations, wherein each subblock combination comprises any first subblock and any second subblock; for each subblock combination, determining a column number range of an element in the first subblock in the subblock combination and a row number range of an element in the second subblock in the subblock combination; and

if there is an intersection between the column number range and the row number range, determining that the subblock combination is the target subblock combination; or

if there is no intersection between the column number range and the row number range, determining that the subblock combination is not the target subblock combination.

10. The method according to any one of claims 1 to 9, wherein the matrix computing apparatus is configured to compute a product result of the first subblock and the second subblock based on the input to-be-multiplied elements in the first subblock and the second subblock.

11. The method according to claim 10, wherein the matrix computing apparatus determines the product result of the first matrix and the second matrix in the following manner:

dividing all the target subblock combinations into a plurality of sets, wherein one or more first subblocks comprised in one or more target subblock combinations in each set are located in a same row of the first matrix, and one or more second subblocks comprised in the one or more target subblock combinations in each set are located in a same column of the second matrix; and

for each set, sequentially inputting the one or more target subblock combinations in the set into the matrix computing apparatus, and computing, by the matrix computing apparatus, a product result of each target subblock combination, and adding product results of the one or more target subblock combinations in the set, wherein an addition result is one subblock in the product result of the first matrix and the second matrix.

12. A matrix computing apparatus, wherein the matrix computing apparatus comprises a comparison unit and a computing unit;

the comparison unit is configured to compare, based on input data of a to-be-multiplied first submatrix and input data of a to-be-multiplied second submatrix, location information of any non-zero element in the first submatrix with location information of any non-zero element in the second submatrix, to determine one or more pairs of to-be-multiplied elements in the first submatrix and the second submatrix, wherein the input data of the first submatrix comprises a value of an element in the first submatrix and the location information indicating a location, in a first matrix, of the non-zero element in the first submatrix, and the input data of the second submatrix comprises a value of an element in the second submatrix and the location information indicating a location, in a second matrix, of the non-zero element in the second submatrix; and

the computing unit is configured to perform a multiply-add operation on the one or more pairs of to-be-multiplied elements, to obtain a product result of the first submatrix and the second submatrix.

13. The apparatus according to claim 12, wherein the location information comprises a row number and a column number of the non-zero element; and

the comparison unit is specifically configured to: compare whether a column number of any element in the first submatrix is the same as a row number of any element in the second submatrix; and if the column number of the any element in the first submatrix is the same as the row number of the any element in the second submatrix, determine that the any element in the first submatrix and the any element in the second submatrix are a pair of to-be-multiplied elements, or if the column number of the any element in the first submatrix is different from the row number of the any element in the second submatrix, determine that the any element in the first submatrix and the any element in the second submatrix are not to-be-multiplied elements.

14. The apparatus according to claim 12 or 13, wherein when performing the multiply-add operation on the one or more pairs of to-be-multiplied elements, the computing unit is specifically configured to:
perform, based on any row vector in the first submatrix and any column vector in the second submatrix, the multiply-add operation on a to-be-multiplied element comprised in the row vector and a to-be-multiplied element comprised in the column vector, to obtain a vector product result of the row vector and the column vector, wherein the vector multiply-add result is an element in the product result of the first submatrix and the second submatrix.

15. The apparatus according to any one of claims 12 to 14, wherein the computing unit is further configured to: add the product result to a third submatrix stored in an accumulator, and write an addition result back to the accumulator.

16. The apparatus according to any one of claims 12 to 14, wherein the matrix computing apparatus further comprises a detection module; and the detection module is configured to detect whether the first submatrix and the second submatrix are overlap matrices, wherein the overlap matrices mean that at least one element in the first submatrix and at least one element in the second subblock are to-be-multiplied elements.

17. The apparatus according to claim 16, wherein the to-be-multiplied element means that a column number of an element in the first subblock is the same as a row number of an element in the second subblock.

18. A computing device, wherein the apparatus comprises a processor and a memory;

the memory is configured to store computer program instructions; and
the processor invokes the computer program instructions in the memory to perform the method according to any one of claims 1 to 11.

19. A computing device, wherein the apparatus comprises a processor, a memory, and the matrix computing apparatus according to any one of claims 12 to 17;

the memory is configured to store computer program instructions; and
the processor invokes the computer program instructions in the memory to perform the method according to any one of claims 1 to 11.

20. A computer-readable storage medium, wherein when the computer-readable storage medium is executed by a storage device, the storage device performs the method according to any one of claims 1 to 11.

**CSR**

Index pointers (row offset values)

| 0 | 2 | 3 | 3 | 3 | 6 | 6 | 7 |
|---|---|---|---|---|---|---|---|

Indices (column numbers)

| 0 | 2 | 2 | 2 | 3 | 4 | 3 |
|---|---|---|---|---|---|---|

Data (value)

| 8 | 2 | 5 | 7 | 1 | 2 | 9 |
|---|---|---|---|---|---|---|

FIG. 1

**CSC**

Index pointers (column offset values)

| 0 | 1 | 1 | 4 | 6 | 7 |
|---|---|---|---|---|---|

Indices (row numbers)

| 0 | 0 | 1 | 4 | 4 | 6 | 4 |
|---|---|---|---|---|---|---|

Data (value)

| 8 | 2 | 5 | 7 | 1 | 2 | 9 |
|---|---|---|---|---|---|---|

FIG. 2

| $A_{11}$ | $A_{12}$ | $A_{13}$ | $A_{14}$ |
|---|---|---|---|
| $A_{21}$ | $A_{22}$ | $A_{23}$ | $A_{24}$ |
| $A_{31}$ | $A_{32}$ | $A_{33}$ | $A_{34}$ |
| $A_{41}$ | $A_{42}$ | $A_{43}$ | $A_{44}$ |

| $B_{11}$ | $B_{12}$ | $B_{13}$ | $B_{14}$ |
|---|---|---|---|
| $B_{21}$ | $B_{22}$ | $B_{23}$ | $B_{24}$ |
| $B_{31}$ | $B_{32}$ | $B_{33}$ | $B_{34}$ |
| $B_{41}$ | $B_{42}$ | $B_{43}$ | $B_{44}$ |

A                    B

FIG. 3

Structured pruning (2:4)

Matrix $w_0$

Value    Indices (indices)

Matrix $x_0$

Matrix C=Matrix A× Matrix B

Legends:

■ indicates a zero element

□ indicates a non-zero element

FIG. 4

EP 4 546 173 A1

FIG. 5

601

Obtain input data of two to-be-multiplied matrices

602

Perform, by row, block division on input data of a first matrix at a granularity of a subblock whose scale is m×n, to obtain a plurality of first subblocks

603

Perform, by column, block division on input data of a second matrix at a granularity of a subblock whose scale is n×r, to obtain a plurality of second subblocks

604

Determine a target subblock combination, where each target subblock combination includes two to-be-multiplied subblocks

605

Use each target subblock combination as input data of a matrix computing apparatus 10, to obtain a product result of the first matrix×the second matrix

FIG. 6

First matrix

Second matrix

Legends:

■ indicates a zero element

□ indicates a non-zero element

Perform compression by row

Perform compression by column

S601: Obtain input data
First compressed matrix (CSR/COO)

Second compressed matrix (CSC/COO)

Legend: □ includes a value and an original subscript of a non-zero element

S602: Perform block division by row

$a_{11}$  $a_{12}$  $a_{13}$  $a_{14}$

$a_{21}$  $a_{22}$  $a_{23}$  $a_{24}$

S603: Perform block division by column

$b_{11}$  $b_{12}$
$b_{21}$  $b_{22}$
$b_{31}$  $b_{32}$
$b_{41}$

S604: Overlapping test

$(a_{11}\ b_{11})$, $(a_{11}\ b_{21})$
$(a_{12}\ b_{31})$, $(a_{14}\ b_{41})$

$(a_{11}\ b_{12})$, $(a_{13}\ b_{32})$

$(a_{21}\ b_{21})$, $(a_{23}\ b_{41})$

$(a_{22}\ b_{22})$, $(a_{23}\ b_{32})$

S605: Sequentially input a plurality of target subblock combinations

Matrix accelerator

FIG. 7

EP 4 546 173 A1

FIG. 8

EP 4 546 173 A1

FIG. 9

FIG. 10

EP 4 546 173 A1

FIG. 11

1200

Apparatus

1203

1201

Memory

Processor

Sparse BLAS (sparse matrix function library)

1205

1202

1204

Matrix computing apparatus

Communication interface

FIG. 12

## INTERNATIONAL SEARCH REPORT

| International application No. |
|---|
| **PCT/CN2023/102182** |

| **A.** | **CLASSIFICATION OF SUBJECT MATTER** |
|---|---|
| | G06F 17/16(2006.01)i |

According to International Patent Classification (IPC) or to both national classification and IPC

| **B.** | **FIELDS SEARCHED** |
|---|---|

Minimum documentation searched (classification system followed by classification symbols)

IPC:G06F

Documentation searched other than minimum documentation to the extent that such documents are included in the fields searched

Electronic data base consulted during the international search (name of data base and, where practicable, search terms used)

CNTXT, ENTXT, ENTXTC, DWPI, CNKI: 矩阵, 乘, 计算, 块, 行, 列, 加, 点积, 稀疏, 稠密, 编码; matrix, multipl+, add+, comput+, calculat+, block, line, row, column, dot product, scalar product, sparse, dense

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| X | CN 113168430 A (ADVANCED MICRO DEVICES, INC.) 23 July 2021 (2021-07-23) claims 1-20, description, paragraphs 8-63, and figures 1-5 | 1-20 |
| X | CN 104899182 A (NATIONAL UNIVERSITY OF DEFENSE TECHNOLOGY OF PLA) 09 September 2015 (2015-09-09) claims 1-5, description, paragraphs 48-135, and figures 1-9 | 1-20 |
| A | CN 109710213 A (GUANGDONG INSPUR BIG DATA RESEARCH CO., LTD.) 03 May 2019 (2019-05-03) entire document | 1-20 |
| A | CN 114065123 A (HUAWEI TECHNOLOGIES CO., LTD.) 18 February 2022 (2022-02-18) entire document | 1-20 |
| A | CN 112732222 A (SUZHOU INSPUR INTELLIGENT TECHNOLOGY CO., LTD.) 30 April 2021 (2021-04-30) entire document | 1-20 |
| A | US 2014108481 A1 (MICROSOFT CORP.) 17 April 2014 (2014-04-17) entire document | 1-20 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **26 July 2023** | **07 August 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

| International application No. |
| --- |
| **PCT/CN2023/102182** |

| Patent document cited in search report | | | Publication date (day/month/year) | Patent family member(s) | | | Publication date (day/month/year) |
| --- | --- | --- | --- | --- | --- | --- | --- |
| CN | 113168430 | A | 23 July 2021 | US | 2020133991 | A1 | 30 April 2020 |
| | | | | US | 11093580 | B2 | 17 August 2021 |
| | | | | WO | 2020091848 | A1 | 07 May 2020 |
| | | | | JP | 2022506418 | A | 17 January 2022 |
| | | | | KR | 20210071073 | A | 15 June 2021 |
| | | | | JP | 2023089161 | A | 27 June 2023 |
| | | | | EP | 3891626 | A1 | 13 October 2021 |
| | | | | EP | 3891626 | A4 | 10 August 2022 |
| | | | | IN | 202117021860 | A | 29 October 2021 |
| CN | 104899182 | A | 09 September 2015 | CN | 104899182 | B | 31 October 2017 |
| CN | 109710213 | A | 03 May 2019 | None | | | |
| CN | 114065123 | A | 18 February 2022 | WO | 2022022117 | A1 | 03 February 2022 |
| CN | 112732222 | A | 30 April 2021 | CN | 112732222 | B | 10 January 2023 |
| | | | | WO | 2022148181 | A1 | 14 July 2022 |
| US | 2014108481 | A1 | 17 April 2014 | US | 9317482 | B2 | 19 April 2016 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210835952X